(19) Europäisches Patentamt
European Patent Office
Office européen des brevets

(11) **EP 3 605 756 A1**

(12) **EUROPEAN PATENT APPLICATION**
published in accordance with Art. 153(4) EPC

(43) Date of publication:
**05.02.2020 Bulletin 2020/06**

(21) Application number: **18777697.6**

(22) Date of filing: **22.03.2018**

(51) Int Cl.:
***H01S 5/36*** *(2006.01)* ***C09K 11/06*** *(2006.01)*
***H01L 51/50*** *(2006.01)*

(86) International application number:
**PCT/JP2018/011288**

(87) International publication number:
**WO 2018/180838 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2017 JP 2017072935**

(71) Applicants:
- **Kyushu University, National University Corporation Nishi-ku Fukuoka-shi Fukuoka 819-0395 (JP)**
- **Kwansei Gakuin Educational Foundation Nishinomiya-shi, Hyogo 662-8501 (JP)**

(72) Inventors:
- **NAKANOTANI, Hajime Fukuoka-shi, Fukuoka 8190395 (JP)**
- **FURUKAWA, Taro Fukuoka-shi, Fukuoka 8190395 (JP)**
- **ADACHI, Chihaya Fukuoka-shi, Fukuoka 8190395 (JP)**
- **HATAKEYAMA, Takuji Fukuoka-shi, Fukuoka 8190395 (JP)**

(74) Representative: **Zimmermann & Partner Patentanwälte mbB Postfach 330 920 80069 München (DE)**

(54) **ORGANIC SEMICONDUCTOR LASER ELEMENT**

(57) An organic semiconductor laser device containing a compound represented by the following formula has a low threshold value for laser emission and has excellent laser characteristics. The ring A, the ring B and the ring C each are a aryl ring or a heteroaryl ring; $Y^1$ is B, P, P=O, P=S, Al, Ga, As, Si-R or Ge-R; R is an aryl group or an alkyl group; $X^1$ and $X^2$ each are O, N-R', S or Se; R' is an aryl group, a heteroaryl group or an alky group.

[Fig. 1]

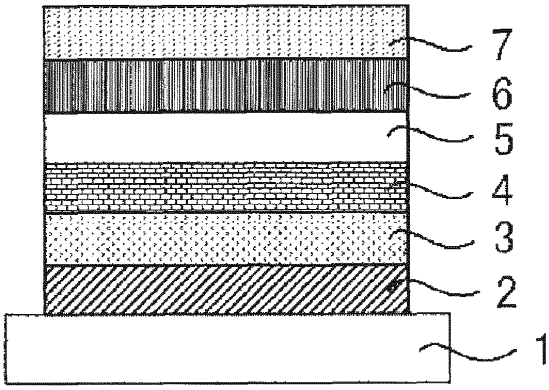


EP 3 605 756 A1

## Description

### Technical Field

The present invention relates to an organic semiconductor laser device using an organic compound as the light emitting material therein.

### Background Art

Development of an organic semiconductor laser device using an organic material the light emitting material therein is being made actively.

For example, since Sorokin, Lankard, Schafer, et al. have first reported that strong photoexcitation of a light emitting organic dye dissolved in an organic solvent gives laser light, laser using an organic dye (dye laser) has achieved remarkable development (for example, see NPLs 1 to 5).

On the other hand, an organic semiconductor laser device using a rare earth element such as an Eu complex has also been proposed (see NPL 6). The organic semiconductor laser device is to form population inversion based on the long lifetime of the triplet exciton of the Eu complex therein, and accordingly to realize a current excitation-type organic semiconductor laser device.

Further, there are known many reports confirming amplified spontaneous emission (ASE) from a thin film (organic solid thin film) formed by doping an organic dye in a medium of a high-molecular compound or a low-molecular compound and laser oscillation from such a thin film with an oscillator structure (for example, see NPLs 7 to 11).

### Citation List

### Non-Patent Literature

NPL 1 : Sorokin, P. P.; Lankard, J. R. IBM J. Res. Develop. 1966, 10, 162-163

NPL 2 : Schafer, F. P.; Schmidt, W.; Volze, J. Appl. Phys. Lett. 1966, 9, 306-309

NPL 3 : Soffer B. H.; McFarland, B. B. Appl. Phys. Lett. 1967, 10, 266-267

NPL 4 : Sorokin, P. P.; Lankard, J. R.; Moruzzi, V. L.; Hammond, E. C. J. Chem. Phys. 1968, 48, 4726-4741

NPL 5 : Sorokin, P. P.; Lankard, J. R.; Moruzzi, V. L.; Lurio, A. Appl. Phys. Lett. 1969, 15, 179-181

NPL 6 : Chihaya Adachi, Student Advanced technical paper, 1989, Nippon Kogyo Shimbun

NPL 7 : Tessler, N.; Denton, G. J.; Friend, R. H. Nature 1996, 382, 695-697

NPL 8 : Frolov, S. V.; Ozaki, M.; Gellermann, W.; Vardeny, Z. V.; Yoshino, K. Jpn. J. Appl. Phys. 1996, 35, L1371-L1373

NPL 9 : Hide, F.; Diaz-Garcia, M. A.; Schwartz, B. J.; Andersson, M. R.; Pei, Q.; Heeger, A. J. Science 1996, 273, 1833-1836

NPL 10 : Kozlov, V. G.; Bulovic, V.; Burrows, P. E.; Forrest, S. R.; Nature 1997, 389, 362-364

NPL 11 : Berggren, M.; Dodabalapur, A.; Slusher, R. E.; Bao, Z.; Nature 1997, 389, 466-469


### Summary of Invention

### Technical Problem

Regarding organic semiconductor laser devices, development of a light emitting material capable of lowering the threshold value for laser emission, especially capable of effectively reducing the threshold current density for realizing a current excitation-type organic semiconductor laser device is earnestly desired.

A light emitting organic compound is grouped into a fluorescent material, a phosphorescent material and a delayed fluorescent material depending on the type of the exciton therein to contribute toward emission. Among these, the fluorescent material emits fluorescence through radiative deactivation of the singlet exciton therein excited from the ground state, the phosphorescent material emits phosphorescence through radiative deactivation of the triplet exciton therein excited from the ground state and of the triplet exciton generated from the singlet exciton therein through intersystem crossing, and the delayed fluorescent material emits fluorescence through radiative excitation of the singlet exciton therein excited from the ground state and emits fluorescence (delayed fluorescence) through radiative deactivation of the singlet exciton generated from the triplet exciton therein through reverse intersystem crossing. Here, in current excitation of an organic compound, the formation probability of the singlet exciton to the triplet exciton in the

compound is 25/75, but as described above, in a phosphorescent material, the triplet exciton generated from the singlet exciton through intersystem crossing contributes toward emission, while in a delayed fluorescent material, the singlet exciton generated from the triplet exciton through reverse intersystem crossing contributes toward emission, and therefore in these the energy from both the singlet exciton and the triplet exciton can be utilized for emission, and in theory, these two could attain 100% emission efficiency. Consequently, for realizing an organic semiconductor laser device having a low threshold value, use of a phosphorescent material or a delayed fluorescent material is considered to be desirable.

From such viewpoints, laser materials used in organic semiconductor laser devices heretofore proposed in the art are discussed, and the organic dyes used in all the above-mentioned non-patent literature are fluorescent materials, which could not effectively utilize the energy of the triplet exciton therein for emission. Consequently, in the case where use of these organic dyes in current excitation-type laser devices is simulated, the estimated threshold current density is extremely high and it is difficult to obtain laser light at a current density falling within a practicable range. In fact, current excitation-type organic laser devices using such organic dyes are not as yet realized.

On the other hand, a rare earth complex is a phosphorescent material and can utilize the energy of both the singlet exciton and the triplet exciton therein for emission, and therefore the threshold value for laser emission could be seemingly lowered. However, the triplet exciton having a long lifetime generally causes strong triplet excitation state absorption, which therefore may bring about a risk of optical loss. In addition, of the triplet exciton, the radiative decay rate kr from the excited triplet state $T_1$ to the ground state So is small, and therefore, the Einstein B coefficient (stimulated emission coefficient) thereof that bears a proportionate relationship to kr is also small. In the phosphorescent material, the triplet exciton greatly contributes toward emission, and therefore it is difficult to realize a laser device having a low threshold value using a phosphorescent material.

Given the situation, the present inventors have made assiduous studies for the purpose of providing a material capable of reducing the threshold value of an organic semiconductor laser device to attain excellent laser characteristics.

Solution to Problem

As a result of assiduous studies, the present inventors have found that, using a polycyclic aromatic compound having a structure where three aryl rings or heteroaryl rings bond at specific sites, an organic semiconductor laser device having an extremely low threshold value for laser emission and excellent in laser characteristics can be provided. The present invention has been proposed on the basis of these findings, and specifically includes the following constitutions.

[1] An organic semiconductor laser device containing a compound represented by the following formula (1):

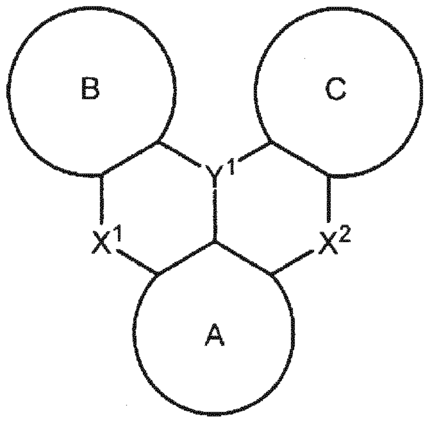

(1)

wherein:

the ring A, the ring B and the ring C each independently represent an aryl ring or a heteroaryl ring, and at least one hydrogen in these rings may be substituted;

$Y^1$ represents B, P, P=O, P=S, Al, Ga, As, Si-R or Ge-R, and R in Si-R and Ge-R represents an aryl group or an alkyl group,

$X^1$ and $X^2$ each independently represent O, N-R, S or Se, R in N-R represents an optionally substituted aryl group, an optionally substituted heteroaryl group, or an alkyl group, and R in N-R may bond to at least one of the ring A, the ring B and the ring C via a linking group or a single bond, and

at least one hydrogen atom in the compound or the structure represented by the formula (1) may be substituted with a halogen atom or a deuterium atom.

[2] The organic semiconductor laser device according to [1], wherein in the formula (1):

the ring A, the ring B and the ring C each independently represent an aryl ring or a heteroaryl ring, and at least one hydrogen in these rings may be substituted with a substituted or unsubstituted aryl group, a substituted or unsubstituted heteroaryl group, a substituted or unsubstituted diarylamino group, a substituted or unsubstituted diheteroarylamino group, a substituted or unsubstituted arylheteroarylamino group, a substituted or unsubstituted alkyl group, a substituted or unsubstituted alkoxy group, or a substituted or unsubstituted aryloxy group, and these rings each have a 5-membered ring or a 6-membered ring that shares a bond with the fused bicyclic structure formed of $Y^1$, $X^1$ and $X^2$ in the center of the formula,
$Y^1$ represents B, P, P=O, P=S, Al, Ga, As, Si-R or Ge-R, and R in Si-R and Ge-R represents an aryl group or an alkyl group,
$X^1$ and $X^2$ each independently represent O, N-R, S or Se, R in N-R represents an aryl group optionally substituted with an alkyl group or an aryl group, a heteroaryl group optionally substituted with an alkyl group, or an alkyl group, and R in N-R may bond to at least one of the ring A, the ring B and the ring C via -O-, -S-, $-C(-R)_2-$ or a single bond, and R in $-C(-R)_2-$ represents a hydrogen atom or an alkyl group, and
at least one hydrogen atom in the compound or the structure represented by the formula (1) may be substituted with a halogen atom or a deuterium atom.

[3] The organic semiconductor laser device according to [1], wherein the compound represented by the formula (1) is a compound represented by the following formula (2):

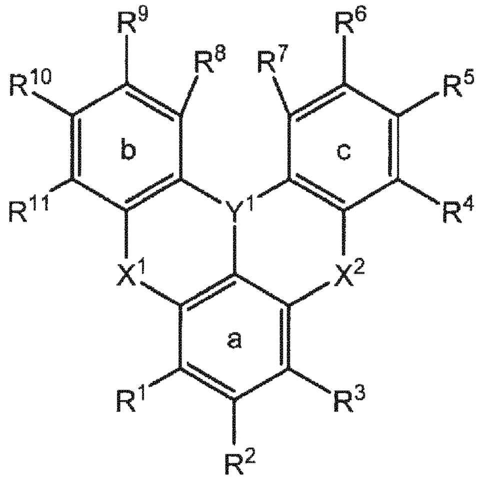

(2)

wherein:

$R^1$, $R^2$, $R^3$, $R^4$, $R^5$, $R^6$, $R^7$, $R^8$, $R^9$, $R^{10}$ and $R^{11}$ each independently represent a hydrogen atom, an aryl group, a heteroaryl group, a diarylamino group, a diheteroarylamino group, an arylheteroarylamino group, an alkyl group, an alkoxy group or an aryloxy group, at least one hydrogen atom in these may be substituted with an aryl group, a heteroaryl group or an alkyl group, adjacent groups among $R^1$ to $R^{11}$ may bond to each other to form an aryl ring or a heteroaryl ring along with the ring a, the ring b or the ring c, at least one hydrogen atom in the formed ring may be substituted with an aryl group, a heteroaryl group, a diarylamino group, a diheteroarylamino group, an arylheteroarylamino group, an alkyl group, an alkoxy group or an aryloxy group, and at least one hydrogen atom in these may be substituted with an aryl group, a heteroaryl group or an alkyl group,
$Y^1$ represents B, P, P=O, P=S, Al, Ga, As, Si-R or Ge-R, R in Si-R and Ge-R represents an aryl group having 6 to 12 carbon atoms or an alkyl group having 1 to 6 carbon atoms,
$X^1$ and $X^2$ each independently represent O, N-R, S or Se, R in N-R represents an aryl group having 6 to 12 carbon atoms, a heteroaryl group having 2 to 15 carbon atoms or an alkyl group having 1 to 6 carbon atoms, R in N-R may bond to at least one of the ring a, the ring b and the ring c via -O-, -S-, $-C(-R)_2-$ or a single bond, and R in $-C(-R)_2-$ represents an alkyl group having 1 to 6 carbon atoms, and
at least one hydrogen atom in the compound represented by the formula (2) may be substituted with a halogen atom or a deuterium atom.

[4] The organic semiconductor laser device according to [3], wherein in the formula (2):

$R^1$, $R^2$, $R^3$, $R^4$, $R^5$, $R^6$, $R^7$, $R^8$, $R^9$, $R^{10}$ and $R^{11}$ each independently represent a hydrogen atom, an aryl group having 6 to 30 carbon atoms, a heteroaryl group having 2 to 30 carbon atoms or a diarylamino group (provided that the aryl group is an aryl group having 6 to 12 carbon atoms), and adjacent groups of $R^1$ to $R^{11}$ may bond to each other to form an aryl ring having 9 to 16 carbon atoms or a heteroaryl ring having 6 to 15 carbon atoms along with the ring a, the ring b or the ring c, and at least one hydrogen atom in the formed ring may be substituted with an aryl group having 6 to 10 carbon atoms,
$Y^1$ represents B, P, P=O, P=S or Si-R, R in Si-R represents an aryl group having 6 to 10 carbon atoms or an alkyl group having 1 to 4 carbon atoms,
$X^1$ and $X^2$ each independently represent O, N-R or S, R in N-R represents an aryl group having 6 to 10 carbon atoms or an alkyl group having 1 to 4 carbon atoms, and
at least one hydrogen atom in the compound represented by the formula (2) may be substituted with a halogen atom or a deuterium atom.

[5] The organic semiconductor laser device according to [3], wherein in the formula (2), $Y^1$ is B.
[6] The organic semiconductor laser device according to [3] or [5], wherein in the formula (2), $X^1$ and $X^2$ each are N-R, and R is an aryl group optionally substituted with an aryl group.
[7] The organic semiconductor laser device according to any one of [3], [5] and [6], wherein in the formula (2), at least one of $R^4$ to $R^6$ is a diarylamino group, and at least one of $R^9$ to $R^{11}$ is an aryl group.
[8] The organic semiconductor laser device according to [7], wherein among $R^1$, $R^2$, $R^3$, $R^4$, $R^5$, $R^6$, $R^7$, $R^8$, $R^9$, $R^{10}$ and $R^{11}$ in the formula (2), at least one of $R^4$ to $R^6$ is a diarylamino group, at least one of $R^9$ to $R^{11}$ is an aryl group, and the other(s) is(are) hydrogen atom(s).
[9] The organic semiconductor laser device according to any one of [1] to [8], which is a photoexcitation-type organic semiconductor laser device.
[10] The organic semiconductor laser device according to any one of [1] to [8], which is a current excitation-type organic semiconductor laser device.
[11] The organic semiconductor laser device according to [10], which has a light emitting layer arranged between an anode and a cathode and wherein the light emitting layer contains the compound represented by the formula (1).
[12] The organic semiconductor laser device according to [11], wherein the concentration of the compound represented by the formula (1) in the light emitting layer is 1 to 25% by weight relative to the total weight of the light emitting layer.

Advantageous Effects of Invention

The organic semiconductor laser device of the present invention has a low threshold value for laser emission and can realize excellent laser characteristics.

Brief Description of Drawings

[Fig. 1] This is a schematic cross-sectional view showing a layer configuration example of an organic semiconductor laser device of the present invention.
[Fig. 2] This is an emission spectrum of an organic semiconductor laser device having a single film (thickness 85 nm) of a compound 1.
[Fig. 3] This is a graph showing excitation light intensity dependency of the emission intensity and the full width at half maximum (FWHM) of the emission peak of an organic semiconductor laser device having a single film (thickness 85 nm) of a compound 1.
[Fig. 4] This is an emission spectrum of an organic semiconductor laser device having a single film (thickness 100 nm) of a compound 1.
[Fig. 5] This is a graph showing excitation light intensity dependency of the emission intensity of an organic semiconductor laser device having a single film (thickness 100 nm) of a compound 1.
[Fig. 6] This is an emission spectrum of an organic semiconductor laser device having a doped film containing 1% by weight of a compound 1.
[Fig. 7] This is a graph showing excitation light intensity dependency of the emission intensity and the full width at half maximum (FWHM) of the emission peak of an organic semiconductor laser device having a doped film containing 1% by weight of a compound 1.

[Fig. 8] This is an emission spectrum of an organic semiconductor laser device having a doped film containing 6% by weight of a compound 1.

[Fig. 9] This is a graph showing excitation light intensity dependency of the emission intensity and the full width at half maximum (FWHM) of the emission peak of an organic semiconductor laser device having a doped film containing 6% by weight of a compound 1.

[Fig. 10] This is an emission spectrum of an organic semiconductor laser device having a doped film containing 15% by weight of a compound 1.

[Fig. 11] This is a graph showing excitation light intensity dependency of the emission intensity of an organic semiconductor laser device having a doped film containing 15% by weight of a compound 1.

[Fig. 12] This is an emission spectrum of an organic semiconductor laser device having a doped film containing 25% by weight of a compound 1.

[Fig. 13] This is a graph showing excitation light intensity dependency of the emission intensity of an organic semiconductor laser device having a doped film containing 25% by weight of a compound 1.

[Fig. 14] This is an emission spectrum of an organic semiconductor laser device having a doped film containing 50% by weight of a compound 1.

[Fig. 15] This is a graph showing excitation light intensity dependency of the emission intensity of an organic semiconductor laser device having a doped film containing 50% by weight of a compound 1.

[Fig. 16] This is an emission spectrum of an organic semiconductor laser device having a doped film containing 6% by weight of a compound 2.

[Fig. 17] This is a graph showing excitation light intensity dependency of the emission intensity of an organic semiconductor laser device having a doped film containing 6% by weight of a compound 2.

Description of Embodiments

The contents of the invention will be described in detail below. The constitutional elements may be described below with reference to representative embodiments and specific examples of the invention, but the invention is not limited to the embodiments and the examples. In the description, a numerical value range expressed using "A to B" denotes a range including numerical values before and after "to" as a minimum value and a maximum value, respectively. The hydrogen atom existing in the molecule of the compound for use in the present invention is not specifically limited in point of the isotope species thereof, and for example, all hydrogen atoms in the molecule may be $^1H$, or a part or all thereof may be $^2H$ (deuterium D).

<Organic Semiconductor Laser Device>

The organic semiconductor laser device of the present invention is characterized by containing the compound represented by the following formula (1).

The organic semiconductor laser device containing a compound represented by the formula (1) has a low threshold value for laser emission and has excellent laser characteristics. This may be considered to be because the compound represented by the formula (1) is a thermal activation-type delayed fluorescent material and the emission peak thereof is steal and the distribution range of the fluorescence quantum yield thereof is narrow. The reason is described below.

Here, "thermal activation-type delayed fluorescent material" in this description means a material which, when given energy to be in an excited state, absorbs the thermal energy to undergo reverse intersystem crossing to be from in an excited triplet state to an excited singlet state and which emits fluorescence when restoring from the excited singlet state to a ground state. The fluorescence to radiate through the route is generally observed later than the fluorescence to radiate from the excited singlet state having directly transitioned from the ground state, and is therefore referred to as "delayed fluorescence". In this description, in the case where a thin film containing a target compound is measured for the transient decay curve in emission at 300 K, fluorescence emission having an emission lifetime is 0.2 μs or more is observed along with instantaneous fluorescence (fluorescence lifetime is 50 ns or less), then the target compound is determined to be "a thermal activation-type delayed fluorescent material".

In such a delayed fluorescent material, the fluorescence from the singlet exciton generated through reverse intersystem crossing from the triplet exciton also contributes toward emission along with the fluorescence from the singlet exciton excited from the ground state. Further, in the case of a thermal activation-type delayed fluorescent material, the reverse intersystem crossing is promoted by the heat generated by the device containing the material. Consequently, when a thermal activation-type delayed fluorescent material is used as a material for an organic semiconductor laser device, the excited triplet energy thereof can be converted into an excited singlet energy and can be made to effectively contribute toward light emission along with the excited singlet energy thereof. As a result, as compared with a case using a fluorescent material, spontaneous emission and stimulated emission can be attained efficiently, which brings about

reduction in the threshold value for laser emission.

Naturally, of such a delayed fluorescent material, the radiative decay rate kr from the excited singlet state $S_1$ to the ground state So is small, and therefore, the Einstein B coefficient (stimulated emission coefficient) thereof that bears a proportionate relationship to kr tends to be also small. However, the present inventors radiated relatively strong excited light toward a thin film containing a compound represented by the formula (1), and observed an extremely steep emission peak, and have confirmed an extremely narrow distribution range of the fluorescence quantum yield thereof (see Examples given hereinunder).

Here, the threshold energy in an optical amplification process is known to be inversely proportional to the stimulated-emission cross-section $\sigma_{em}(\lambda)$. On the other hand, as shown by the following expression (I), the stimulated-emission cross-section $\sigma_{em}(\lambda)$ is proportional to the distribution $E_f(\lambda)$ of the fluorescence quantum yield at a wavelength $\lambda$. Accordingly, when $E_f(\lambda)$ is large (that is, when the distribution range of the fluorescence quantum yield is narrow), the stimulated-emission cross-section $\sigma_{em}(\lambda)$ could be large even though the radiative decay rate kr (stimulated emission coefficient B) is small, therefore attaining a low threshold energy.

[Math. 1]

$$\sigma_{em}(\lambda) = \frac{h\nu n(\nu)}{c\Phi_f} BE_f(\nu) = \frac{\lambda^4 E_f(\lambda)}{8\pi n^2(\lambda) c\tau_f} \qquad (I)$$

In the expression (I), v represents the frequency of excitation light, $\lambda$ represents the wavelength of excitation light, $\sigma_{em}(\lambda)$ represents the stimulated-emission cross-section at a wavelength $\lambda$, h represents the Plank constant, n(v) represents the refractive index at a frequency v of a thin film (active gain layer), c represents the speed of light, $\phi$f represents the fluorescence quantum yield, B represents the stimulated emission coefficient, Ef(v) represents the distribution of fluorescence quantum yield at a frequency v, Ef($\lambda$) represents the distribution of fluorescence quantum yield at a wavelength $\lambda$, n($\lambda$) represents the refractive index at a wavelength $\lambda$ of a thin film (active gain layer), and $\tau_f$ represents the fluorescence lifetime.

As described above, in the organic semiconductor laser device of the present invention, the compound represented by the formula (1) is a thermal activation-type delayed fluorescent material, and the emission peak thereof is steep and the distribution range of the fluorescence quantum yield thereof is narrow, and consequently, it is presumed that the organic semiconductor laser device of the present invention can attain an extremely low threshold value and can realize excellent laser characteristics.

The structure of the compound represented by the formula (1) for use in the present invention is described below.

[Compound Represented by the Formula (1)]

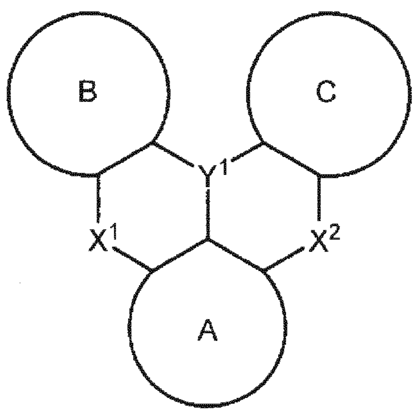

(1)

In the formula (1):

the ring A, the ring B and the ring C each independently represent an aryl ring or a heteroaryl ring, and at least one

hydrogen in these rings may be substituted;

$Y^1$ represents B, P, P=O, P=S, Al, Ga, As, Si-R or Ge-R, and R in Si-R and Ge-R represents an aryl group or an alkyl group,

$X^1$ and $X^2$ each independently represent O, N-R, S or Se, R in N-R represents an optionally substituted aryl group, an optionally substituted heteroaryl group, or an alkyl group, and R in N-R may bond to the ring A, the ring B and/or the ring C via a linking group or a single bond, and

at least one hydrogen atom in the compound or the structure represented by the formula (1) may be substituted with a halogen atom or a deuterium atom.

The compound that the organic semiconductor laser device of the present invention contains may be an oligomer having plural unit structures each represented by the formula (1).

The compound represented by the formula (1) is preferably a compound represented by the following formula (2), or an oligomer having plural unit structures each represented by the formula (2).

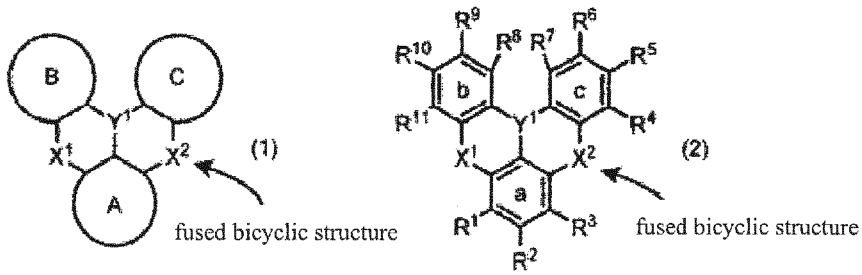


(1) (2)

In the formula (1), the ring A, the ring B and the ring C each independently represent an aryl ring or a heteroaryl ring, and at least one hydrogen in these rings may be substituted with a substituent. The substituent is preferably a substituted or unsubstituted aryl group, a substituted or unsubstituted heteroaryl group, a substituted or unsubstituted diarylamino group, a substituted or unsubstituted diheteroarylamino group, a substituted or unsubstituted arylheteroarylamino group (amino group having an aryl group and a heteroaryl group), a substituted or unsubstituted alkyl group, a substituted or unsubstituted alkoxy group or a substituted or unsubstituted aryloxy group. The substituent in the case where these groups have a substituent includes an aryl group, a heteroaryl group and an alkyl group. The aryl ring or the heteroaryl ring preferably has a 5-membered ring or a 6-membered ring that shares a bond with the fused bicyclic structure formed of $Y^1$, $X^1$ and $X^2$ in the center of the formula (1) (hereinafter this structure is referred to as "structure D").

Here, the "fused bicyclic structure (structure D)" means a structure in which two saturated hydrocarbon rings that are configured to include $Y^1$, $X^1$ and $X^2$ and indicated at the center of the formula (1), are fused. The "6-membered ring that shares a bond with the fused bicyclic structure" means, for example, the ring a (benzene ring (6-membered ring)) fused with the structure D as shown in the formula (2). "The aryl ring or the heteroaryl ring (that is the ring A) has the 6-membered ring" means that the 6-membered ring alone forms the ring A, or any other ring is further fused with the 6-membered ring so as to include the 6-membered ring thereby forming the ring A. In other words, "the aryl ring or the heteroaryl ring (that is the ring A) having a 6-membered ring" as referred to herein means that the 6-membered ring constituting all or a part of the ring A is fused with the structure D. The same explanation shall apply to the "ring B (ring b)", the "ring C (ring c)" or the "5-membered ring".

The ring A (or the ring B, the ring C) in the formula (1) corresponds to the ring a and the substituents $R^1$ to $R^3$ thereof (or the ring b and the substituents $R^4$ to $R^7$ thereof, the ring c and the substituents $R^8$ to $R^{11}$ thereof) in the formula (2). Namely, the formula (2) corresponds to an embodiment of the formula (1) where "the rings A to C each having a 6-membered ring" are selected for the rings A to C. From that viewpoint, each ring in the formula (2) is expressed as the small letters a to c.

In the formula (2), adjacent groups among the substituents $R^1$ to $R^{11}$ in the ring a, the ring b and the ring c may bond to each other to form an aryl ring or a heteroaryl group along with the ring a, the ring b or the ring c, at least one hydrogen atom in the formed ring may be substituted with an aryl group, a heteroaryl group, a diarylamino group, a diheteroarylamino group, an arylheteroarylamino group, an alkyl group, an alkoxy group or an aryloxy group, and at least one hydrogen atom in these may be substituted with an aryl group, a heteroaryl group or an alkyl group. Accordingly, the polycyclic aromatic compound represented by the formula (2) changes the cyclic structure constituting the compound, depending on the mutual bonding mode of the substituents in the ring a, the ring b and the ring c, as shown in the following formulae (2-1) and (2-2). In each formula, the ring A', the ring B' and the ring C' corresponds to the ring A, the ring B and the ring C, respectively, in the formula (1).

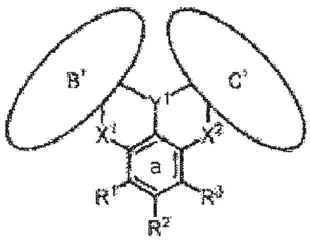

(2-1)

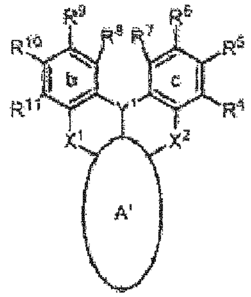

(2-2)

In the above formulae (2-1) and (2-2), the ring A', the ring B' and the ring C' each represent, to be explained in connection with the formula (2), an aryl ring or a heteroaryl ring formed by adjacent groups among the substituents $R^1$ to $R^{11}$ bonding to each other along with the ring a, the ring b and the ring c, respectively (which may also be referred to as a fused ring formed by fusing any other ring structure to the ring a, the ring b or the ring c). Though not shown in the formulae, all the ring a, the ring b and the ring c may be modified into the ring A', the ring B' and the ring C' in some compounds. As known from the above formulae (2-1) and (2-2), for example, $R^8$ on the ring b and $R^7$ on the ring c, $R^{11}$ on the ring b and $R^1$ on the ring a, and $R^4$ on the ring c and $R^3$ on the ring a do not correspond to "adjacent groups", and these do not bond to each other. Namely, "adjacent groups" are groups adjacent to each other on the same ring.

The compounds represented by the above formula (2-1) or (2-2) correspond to, for example, the compounds represented by the formulae (1-2) to (1-17) in WO2015/102118. Specifically, these are compounds having the ring A' (or the ring B' or the ring C') formed by fusing, for example, a benzene ring, an indole ring, a pyrrole ring, a benzofuran ring or a benzothiophene ring to the benzene ring of the ring a (or the ring b or the ring c), in which the fused ring A' (or the fused ring B' or the fused ring C') thus formed is a naphthalene ring, a carbazole ring, an indole ring, a dibenzofuran ring or a dibenzothiophene ring, respectively.

$Y^1$ in the formula (1) represents B, P, P=O, P=S, Al, Ga, As, Si-R or Ge-R, and R in Si-R and Ge-R represents an aryl group or an alkyl group. In the case of P=O, P=S, Si-R or Ge-R, the atom bonding to the ring A, the ring B or the ring C is P, Se or Ge. Preferably, $Y^1$ is B, P, P=O, P=S or Si-R, and is especially preferably B. This explanation shall also apply to $Y^1$ in the formula (2).

$X^1$ and $X^2$ in the formula (1) each independently represent O, N-R, S or Se, R in N-R represents an optionally substituted aryl group, an optionally substituted heteroaryl group, or an alkyl group, and R in N-R may bond to, the ring B and/or the ring C via a linking group or a single bond, and the liking group is preferably -O-, -S- or $-C(-R)_2-$. R in $[-C(-R)_2-]$ represents a hydrogen atom or an alkyl group. This explanation shall also apply to $X^1$ and $X^2$ in the formula (2).

Here, the definition that "R in N-R bonds to the ring A, the ring B and/or the ring C via a linking group or a single bond" in the formula (1) corresponds to the definition that "R in N-R bonds to the ring a, the ring b and/or the ring c via -O-, -S-, $-C(-R)_2-$ or a single bond" in the formula (2).

The definition may be expressed by a compound that has a cyclic structure where $X^1$ and $X^2$ each are taken in the fused ring B' and the fused ring C', as represented by the following formula (2-3-1). Specifically, for example, the compound has the ring B' (or the ring C') formed by fusing any other ring to the ring b (or the ring c) of a benzene ring in the formula (2) in such a manner that the fused ring could take $X^1$ (or $X^2$) therein. The compound of the type corresponds to, for example, the compounds represented by the formulae (1-451) to (1-462) and the compounds represented by the formulae (1-1401) to (1-1460) described in WO2015/102118, in which the fused ring B' (or the fused ring C') formed is, for example, a phenoxazine ring, a phenothiazine ring or an acridine ring.

In addition, the above-mentioned definition may also be expressed by a compound that has a cyclic structure where $X^1$ and/or $X^2$ each are taken in the fused ring A', as represented by the following formula (2-3-2) or (2-3-3). Specifically, for example, the compound has the ring A' formed by fusing any other ring to the ring a of a benzene ring in the formula (2) in such a manner that the fused ring could take $X^1$ (and/or $X^2$) therein. The compound of the type corresponds to, for example, the compounds represented by the formulae (1-471) to (1-479) described in WO2015/102118, in which the fused ring A' formed is, for example, a phenoxazine ring, a phenothiazine ring or an acridine ring.

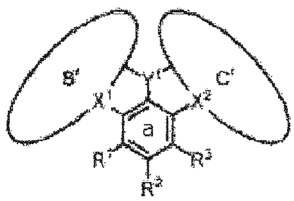 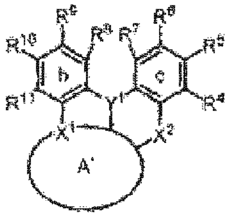 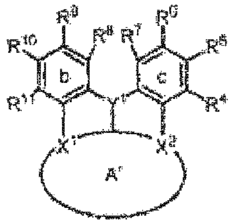

(2-3-1) (2-3-2) (2-3-3)

The "aryl ring" of the ring A, the ring B and the ring C in the formula (1) is, for example, an aryl ring having 6 to 30 carbon atoms, and is preferably an aryl ring having 6 to 16 carbon atoms, more preferably an aryl ring having 6 to 12 carbon atoms, even more preferably an aryl ring having 6 to 10 carbon atoms. The "aryl ring" corresponds to the "aryl ring formed by adjacent groups among $R^1$ to $R^{11}$ bonding to each other along with the ring a, the ring b or the ring c". Since the ring a (or the ring b or the ring c) is formed of a benzene ring having 6 carbon atoms, the total carbon number, 9 of the fused ring of the benzene ring and a 5-membered ring is the lower limit of the carbon number of the aryl ring.

Specific examples of the "aryl ring" include a benzene ring of a monocyclic system, a biphenyl ring of a bicyclic system, a naphthalene ring of a fused bicyclic system, a terphenyl ring (m-terphenyl ring, o-terphenyl ring, p-terphenyl ring) of a tricyclic system, an acenaphthylene ring, a fluorene ring, a phenalene ring and a phenanthrene ring of a fused tetracyclic system, and a perylene ring and a pentacene ring of a fused pentacyclic system.

The "heteroaryl ring" of the ring A, the ring B and the ring C in the formula (1) is, for example, a heteroaryl ring having 2 to 30 carbon atoms, and is preferably a heteroaryl ring having 2 to 25 carbon atoms, more preferably a heteroaryl ring having 2 to 20 carbon atoms, even more preferably a heteroaryl ring having 2 to 15 carbon atoms, and especially preferably a heteroaryl ring having 2 to 10 carbon atoms. In addition, examples of the "heteroaryl ring" include a hetero ring having 1 to 5 hetero atoms selected from oxygen, sulfur and nitrogen, in addition to carbon as the ring constituent atoms. The "heteroaryl ring" corresponds to the "heteroaryl ring formed by adjacent groups among $R^1$ to $R^{11}$ bonding to each other along with the ring a, the ring b or the ring c" defined in the formula (2). Since the ring a (or the ring b or the ring c) is formed of a benzene ring having 6 carbon atoms, the total carbon number, 6 of the fused ring of the benzene ring and a 5-membered ring is the lower limit of the carbon number of the heteroaryl ring.

Specific examples of the "heteroaryl ring" include a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, an indolizine ring, a furan ring, a benzofuran ring, an isobenzofuran ring, a dibenzofuran ring, a thiophene ring, a benzothiophene ring, a dibenzothiophene ring, a furazan ring, an oxadiazole ring, and a thianthrene ring.

At least one hydrogen atom in the above-mentioned "aryl ring" and "heteroaryl ring" may be substitute with a first substituent of a substituted or unsubstituted "aryl group", a substituted or unsubstituted "heteroaryl group", a substituted or unsubstituted "diarylamino group", a substituted or unsubstituted "diheteroarylamino group", a substituted or unsubstituted "arylheteroarylamino group", a substituted or unsubstituted "alkyl group", a substituted or unsubstituted "alkoxy group", or a substituted or unsubstituted "aryloxy group", and examples of the "aryl group" and the "heteroaryl group" of the first substituent, the aryl group of the "diarylamino group", the heteroaryl group of the "diheteroarylamino group", the aryl group and the heteroaryl group of the "arylheteroarylamino group" and the aryl group of the "aryloxy group" include the monovalent groups of the above-mentioned "aryl ring" or "heteroaryl ring".

The "alkyl group" of the first substituent may be linear or branched, and examples thereof include a linear alkyl group having 1 to 24 carbon atoms and a branched alkyl group having 3 to 24 carbon atoms. An alkyl group having 1 to 18 carbon atoms (a branched alkyl group having 3 to 18 carbon atoms) is preferred, an alkyl group having 1 to 12 carbon atoms (a branched alkyl group having 3 to 12 carbon atoms) is more preferred, an alkyl group having 1 to 6 carbon atoms (a branched alkyl group having 3 to 6 carbon atoms is even more preferred, and an alky group having 1 to 4 carbon atoms (a branched alkyl group having 3 to 4 carbon atoms) is especially preferred.

Specific examples of the alkyl group include a methyl group, an ethyl group, an n-propyl group, an isopropyl group, an n-butyl group, an isobutyl group, an s-butyl group, a t-butyl group, an n-pentyl group, an isopentyl group, a neopentyl group, a t-pentyl group, an n-hexyl group, a 1-methylpentyl group, a 4-methyl-2-pentyl group, a 3,3-dimethylbutyl group, a 2-ethylbutyl group, an n-heptyl group, a 1-methylhexyl group, an n-octyl group, a t-octyl group, a 1-methyheptyl group, a 2-ethylhexyl group, a 2-propylpentyl group, an n-nonyl group, a 2,2-dimethylheptyl group, a 2,6-dimethyl-4-heptyl group, a 3,5,5-trimethylhexyl group, an n-decyl group, an n-undecyl group, a 1-methyldecyl group, an n-dodecyl group, an n-tridecyl group, a 1-hexylheptyl group, an n-tetradecyl group, an n-pentadecyl group, an n-hexadecyl group, an n-heptadecyl group, an n-octadecyl group, and an n-eicosyl group.

The "alkoxy group" of the first substituent includes, for example, a linear alkoxy group having 1 to 24 carbon atoms and a branched alkoxy group having 3 to 24 carbon atoms. An alkoxy group having 1 to 18 carbon atoms (a branched alkoxy group having 3 to 18 carbon atoms) is preferred, an alkoxy group having 1 to 12 carbon atoms (a branched alkoxy group having 3 to 12 carbon atoms) is more preferred, an alkoxy group having 1 to 6 carbon atoms (a branched alkoxy group having 3 to 6 carbon atoms) is even more preferred, and an alkoxy group having 1 to 4 carbon atoms (a branched alkoxy group having 3 to 4 carbon atoms) is especially preferred.

Specific examples of the alkoxy group include a methoxy group, an ethoxy group, a propoxy group, an isopropoxy group, a butoxy group, an isobutoxy group, an s-butoxy group, a t-butoxy group, a pentyloxy group, a hexyloxy group, a heptyloxy group, and an octyloxy group.

Regarding the substituted or unsubstituted "aryl group", the substituted or unsubstituted "heteroaryl group", the substituted or unsubstituted "diarylamino group", the substituted or unsubstituted "diheteroarylamino group", the substituted or unsubstituted "arylheteroarylamino group", the substituted or unsubstituted "alkyl group", the substituted or unsubstituted "alkoxy group or the substituted or unsubstituted "aryloxy group" of the first substituent, at least one hydrogen atom in these may be substituted with a second substituent, as so described that they are substituted or unsubstituted. The second substituent is, for example, an aryl group, a heteroaryl group or an alkyl group, and for examples thereof, reference may be made to the description of the monovalent groups of the "aryl ring" and the "heteroaryl ring" mentioned hereinabove and to the description of the "alkyl group" of the first substituent mentioned hereinabove. The aryl group and the heteroaryl group of the second substituent include those in which at least one hydrogen atom is substituted with an aryl group such as a phenyl group (specific examples thereof are mentioned above) or an alkyl group such as a methyl group (specific examples thereof are mentioned above), and such substituted aryl groups and heteroaryl groups are contained in the second substituent. As one example where the second substituent is a carbazolyl group, a carbazolyl group in which at least one hydrogen atom at the 9-position is substituted with an aryl group such as a phenyl group or an alkyl group such as a methyl group is contained in the heteroaryl group of the second substituent.

In $R^1$ to $R^{11}$ in the formula (2), the aryl group and the heteroaryl group, the aryl group in the diarylamino group, the heteroaryl group in the diheteroarylamino group, the aryl group and the heteroaryl group in the arylheteroarylamino group, and the aryl group in the aryloxy group include monovalent groups of the "aryl ring" and the "heteroaryl ring" described hereinabove for the formula (1). For the alkyl group and the alkoxy group in $R^1$ to $R^{11}$, reference may be made to the description of the "alkyl group" and the "alkoxy group" as the first substituent in the formula (1) mentioned hereinabove. The same shall apply also to the aryl group, the heteroaryl group and the alkyl group of the substituent in these groups. In addition, the same shall apply also to the substituents in these rings of the heteroaryl group, the diarylamino group, the diheteroarylamino group, the arylheteroarylamino group, the alkyl group, the alkoxy group and the aryloxy group, and to the additional substituents of the aryl group, the heteroaryl group and the alkyl group in case of aryl ring or heteroaryl ring formed by adjacent groups among $R^1$ to $R^{11}$ bonding to each other along with the ring a, ring b, or ring c.

R in Si-R and Ge-R of $Y^1$ in the formula (1) is an aryl group or an alkyl group, and the aryl group and the alkyl group include those mentioned hereinabove. An aryl group having 6 to 10 carbon atoms (for example, a phenyl group, a naphthyl group), and an alkyl group having 1 to 4 carbon atoms (for example, a methyl group, an ethyl group) are preferred. The same explanation shall apply to $Y^1$ in the formula (2).

R in N-R in $X^1$ and $X^2$ in the formula (1) is an aryl group, a heteroaryl group or an alkyl group optionally substituted with the second substituent mentioned hereinabove, and at least one hydrogen atom in the aryl group and the heteroaryl group may be substituted with, for example, an alkyl group or an aryl group. The aryl group, the heteroaryl group and the alkyl group include those mentioned hereinabove. In particular, an aryl group having 6 to 10 carbon atoms (for example, a phenyl group, a naphthyl group), a heteroaryl group having 2 to 15 carbon atoms (for example, a carbazolyl group), or an alkyl group having 1 to 4 carbon atoms (for example, a methyl group, an ethyl group) is preferred. The same explanation shall apply also to $X^1$ and $X^2$ in the formula (2).

R in the linking group "$-C(-R)_2-$" in the formula (1) is a hydrogen atom or an alkyl group, and the alkyl group includes those mentioned hereinabove. In particular, an alkyl group having 1 to 4 carbon atoms (for example, a methyl group, an ethyl group) is preferred. The same explanation shall apply also to the linking group "$-C(-R)_2-$" in the formula (2).

The compound that the organic semiconductor laser device of the present invention contains may be an oligomer having plural unit structures each represented by the formula (1), preferably an oligomer having plural unit structures each represented by the formula (2). The oligomer is preferably a dimer to a hexamer, more preferably a dimer to a trimer, and especially preferably a dimer. The oligomer may be in any form having a plurality of the above-mentioned unit structures in one compound, and, for example, may be in a form where a plurality of the above-mentioned unit structures bond to each other via a single bond, or a liking group such as an alkylene group having 1 to 3 carbon atoms, a phenylene group or a naphthylene group, and in addition thereto, may also be in a form where rings (the ring A, the ring B or the ring C, or the ring a, the ring b or the ring c) contained in the unit structures bond to each other so as to be

shared by plural unit structures, or may be in a form where rings (the ring A, the ring B or the ring C, or the ring a, the ring b or the ring c) contained in the unit structures bond to each other so as to be fused.

Examples of the oligomer of the type include oligomer compounds represented by the following formula (2-4), formula (2-4-1), formula (2-4-2), formula (2-5-1) to formula (2-5-4) or formula (2-6). The oligomer compounds represented by the following formula (2-4) correspond to, for example, the compound represented by the formula (1-21) described in WO2015/102118. Specifically, with reference to the formula (2), the oligomer compound of the type has two unit structures each represented by the formula (2) in one compound in such a manner that the two unit structures share the benzene ring of the ring a with each other. The oligomer compounds represented by the following formula (2-4-2) correspond to, for example, the compound represented by the formula (1-2666) described in WO2015/102118. Specifically, with reference to the formula (2), the oligomer compound of the type has two unit structures each represented by the formula (2) in one compound in such a manner that the two unit structures share the benzene ring of the ring a with each other. The oligomer compounds represented by the following formulae (2-5-1) to (2-5-4) correspond to, for example, the compounds represented by the formulae (1-22) to (1-25) described in WO2015/102118. Specifically, with reference to the formula (2), the oligomer compounds of the type have plural unit structures each represented by the formula (2) in one compound in such a manner that the plural unit structures share the benzene ring of the ring b (or the ring c) with each other. The oligomer compounds represented by the following formula (2-6) correspond to, for example, the compounds represented by the formulae (1-31) to (1-37) described in WO2015/102118. Specifically, with reference to the formula (2), the oligomer compounds of the type have plural unit structures each represented by the formula (2) in one compound, for example, in such a manner that the benzene ring of the ring b (or the ring a or the ring c) in one unit structure is fused with the benzene ring of the ring b (or the ring a or the ring c) in another unit structure.

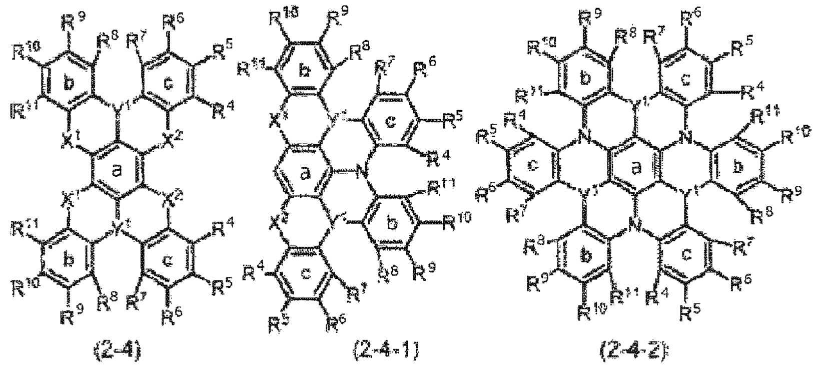

(2-4) (2-4-1) (2-4-2)

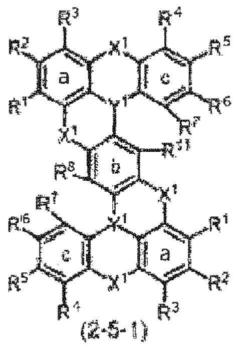

(2-5-1)

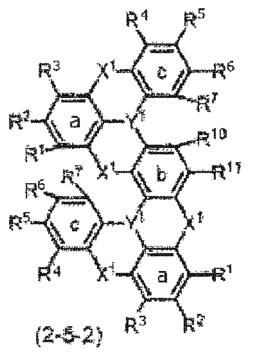

(2-5-2)

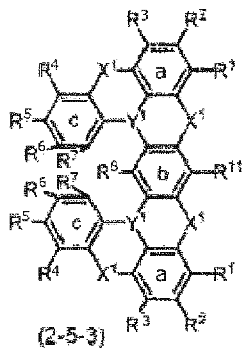

(2-5-3)

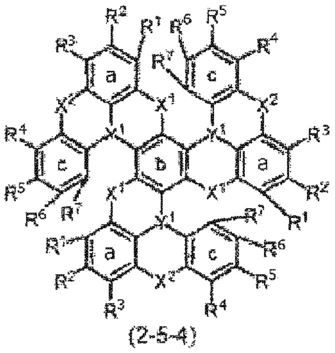

(2-5-4)

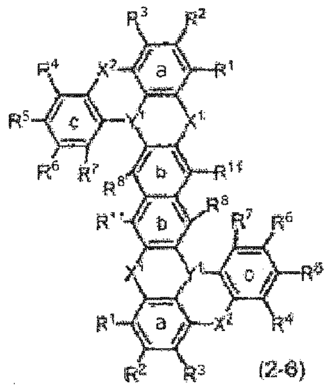

(2-6)

The oligomer compounds may be in any form of a combination of an oligomerization form as expressed by the formula (2-4), (2-4-1) or (2-4-2) and an oligomerization form as expressed by any of the formulae (2-5-1) to (2-5-4) or the formula (2-6), or a combination of an oligomerization form as expressed by any of the formulae (2-5-1) to (2-5-4) and an oligomerization form as expressed by the formula (2-6), or a combination of an oligomerization form as expressed by the formula (2-4), (2-4-1) or (2-4-2) and an oligomerization form as expressed by any of the formulae (2-5-1) to (2-5-4) and an oligomerization form as expressed by the formula (2-6).

All or a part of the hydrogen atoms in the chemical structures of the compounds represented by the formula (1) or (2) and the oligomers thereof may be deuterium atoms.

All or a part of the hydrogen atoms in the chemical structures of the compounds represented by the formula (1) or (2) and the oligomers thereof may be halogen atoms. For example, in the formula (1), the hydrogen atom in the ring A, the ring B, the ring C (the rings A to C each are an aryl ring or a heteroaryl ring), the substituents on the rings A to C, R in Si-R or Ge-R of $Y^1$ (that is, R is an alkyl group or an aryl group), as well as R (that is, an alkyl group or an aryl group) in N-R of $X^1$ and $X^2$ may be substituted with a halogen atom, and among these, there is mentioned one embodiment where all or a part of the hydrogen atoms in the aryl group or the heteroaryl group are substituted with halogen atoms. The halogen atom includes a fluorine atom, a chlorine atom, a bromine atom or an iodine atom, and is preferably a fluorine atom, a chlorine atom or a bromine atom, more preferably a chlorine atom.

The compound represented by the formula (1) that the organic semiconductor laser device of the present invention contains is preferably the compound represented by the formula (2) where $Y^1$ is B, and $X^1$ and $X^2$ each are N-R, more preferably R in N-R is an aryl group optionally substituted with an aryl group. Preferably, at least one of $R^1$ to $R^{11}$ in the formula (2) is a specific substituent defined in the formula (2), and also preferably, all of $R^1$ to $R^{11}$ are hydrogen atoms. Among the substituents that $R^1$ to $R^{11}$ may take as defined in the formula (2), an aryl group and a diarylamino group are preferred, and an aryl group having 6 to 30 carbon atoms and a diarylamino group (where the aryl group has 6 to 12 carbon atoms) are more preferred. In the case where any of $R^1$ to $R^{11}$ is a specific substituent defined in the formula (2), the specific substituent is preferably at least one of $R^4$ to $R^6$ and at least one of $R^9$ to $R^{11}$, more preferably at least one of $R^4$ to $R^6$ is a diarylamino group and at least one of $R^9$ to $R^{11}$ is an aryl group, and even more preferably $R^5$ is a diarylamino group and $R^{10}$ is an aryl group. Among $R^1$ to $R^{11}$, when at least one of $R^4$ to $R^6$ is a diarylamino group and at least one of $R^9$ to $R^{11}$ is an aryl group, the remaining substituents may be hydrogen atoms or may be the other specific substituents defined in the formula (2), but preferably, all the remaining substituents are hydrogen atoms. At least one hydrogen atom in the aryl group and the diarylamino group may be substituted with an aryl group, a heteroaryl group or an alkyl group, but is preferably unsubstituted.

Preferred examples of the compounds represented by the formula (1) are shown below.

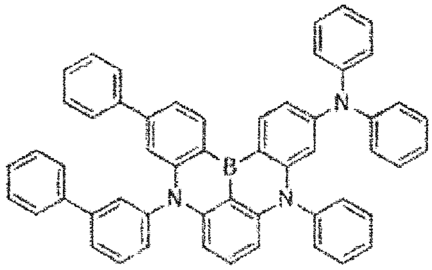

Compound 1

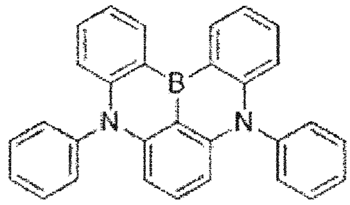

Compound 2

For other specific examples of the compounds represented by the formula (1), paragraphs [0070] to [0280] in WO2015/102118 may be referred to. For methods for producing the compounds represented by the formula (1), paragraphs [0281] to [0316] in WO2015/102118 may be referred to. However, the compounds represented by the formula (1) that may be used in the present invention should not be limitatively interpreted by these specific examples.

[Layer Configuration of Organic Semiconductor Laser Device]

The organic semiconductor laser device of the present invention may be a photoexcitation-type organic semiconductor laser device that emits laser light when the light emitting layer therein is irradiated with excitation light, or may be a current excitation-type organic semiconductor laser device that emits laser light when holes and electrons are injected into the light emitting layer therein and these are recombined to generate energy for laser emission. In any type, the organic semiconductor laser device of the present invention contains the compound represented by the formula (1), and therefore the threshold value for laser emission can be lowered and the device can realize excellent laser characteristics. The photoexcitation-type organic semiconductor laser device is so configured as to have at least a light emitting layer formed on a substrate. The current excitation-type organic semiconductor laser device is so configured as to have at least an anode, a cathode, and an organic layer between the anode and the cathode. The organic layer has at least a light emitting layer, and may a light emitting layer alone, or may have one or more organic layers in addition to a light emitting layer. Such other organic layers include a hole transport layer, a hole injection layer, an electron blocking layer, a hole blocking layer, an electron injection layer, an electron transport layer, and an exciton blocking layer. The hole transport layer may be a hole injection and transport layer that has a hole injection function, and the electron transport layer may be an electron injection and transport layer that has an electron injection function. A specific example of a structure of an organic semiconductor laser device is shown in Fig. 1. In Fig. 1, 1 is a substrate, 2 is an anode, 3 is a hole injection layer, 4 is a hole transport layer, 5 is a light emitting layer, 6 is an electron transport layer, and 7 is a cathode. In a current excitation-type organic semiconductor laser device, the laser light generated in the light emitting layer may be taken outside through the anode or may be taken outside through the cathode, or may also be taken out through the anode and the cathode. The laser light generated in the light emitting layer may be taken outside via the edge of the organic layer.

In the following, the members and the layers of the current excitation-type organic semiconductor laser device are described. The description of the substrate and the light emitting layer may apply also to that of the substrate and the light emitting layer of a photoexcitation-type organic semiconductor laser device.

(Substrate)

Preferably, the organic semiconductor laser device of the present invention is supported by a substrate. Regarding the substrate, a substrate transparent to laser light is used in the case where the organic semiconductor laser device is so configured that laser light is taken out from the substrate side, and preferably, a transparent substrate of glass, transparent plastics or quartz is used. On the other hand, in the case where the organic semiconductor laser device is so configured that laser light is taken out from the side opposite to the substrate side, the substrate is not specifically limited, and in addition to the above-mentioned transparent substrates, any other substrates of silicon, paper or cloth may also be used.

(Anode)

The anode of the organic semiconductor laser device used is preferably formed of as an electrode material a

metal, an alloy or an electroconductive compound each having a large work function (4 eV or more), or a mixture thereof. Specific examples of the electrode material include a metal, such as Au, and an electroconductive transparent material, such as CuI, indium tin oxide (ITO), $SnO_2$ and ZnO. A material that is amorphous and is capable of forming a transparent electroconductive film, such as IDIXO ($In_2O_3$-ZnO), may also be used. The anode may be formed in film formation according to a method of vapor deposition or sputtering with such an electrode material. The formed thin film may be patterned into a desired pattern by a photolithography method, or in the case where the pattern may not require high accuracy (for example, approximately 100 μm or more), the pattern may be formed with a mask having a desired shape on vapor deposition or sputtering of the electrode material. In alternative, in the case where a material capable of being applied as a coating, such as an organic electroconductive compound, is used, a wet film forming method, such as a printing method and a coating method, may be used.

However, in the case where the organic semiconductor laser device is so configured that laser light is taken out through the anode, the anode is required to be transparent to laser light, and is preferably so configured that the laser light transmittance thereof is more than 1%, more preferably more than 10%. Specifically, it is preferable that the above-mentioned conductive transparent material is used for the anode, or a thin film formed of a metal or an alloy in a thickness of 10 to 100 nm is used as the anode.

The sheet resistance of the anode is preferably a few hundred Ω/square or less. The thickness of the anode may be generally selected from a range of 10 to 1,000 nm, and preferably 10 to 200 nm, while depending on the material used.

(Cathode)

The cathode is preferably formed of as an electrode material of a metal (referred to as an electron injection metal), an alloy, an electroconductive compound or a mixture thereof having a smaller work function than that of the material used for the anode. Specific examples of the electrode material include sodium, a sodium-potassium alloy, magnesium, lithium, a magnesium-cupper mixture, a magnesium-silver mixture, a magnesium-aluminum mixture, a magnesium-indium mixture, an aluminum-aluminum oxide ($Al_2O_3$) mixture, indium, a lithium-aluminum mixture, and a rare earth metal. Among these, a mixture of an electron injection metal and a second metal that is a stable metal having a larger work function than the electron injection metal, for example, a magnesium-silver mixture, a magnesium-aluminum mixture, a magnesium-indium mixture, an aluminum-aluminum oxide ($Al_2O_3$) mixture, a lithium-aluminum mixture, and aluminum, are preferred from the standpoint of the electron injection property and the durability against oxidation and the like. The cathode may be produced by forming the electrode material into a thin film by such a method as vapor deposition or sputtering.

However, in the case where the organic semiconductor laser device is so configured that laser light is taken out through the cathode, the cathode is required to be transparent to laser light, and is preferably so configured that the laser light transmittance thereof is more than 1%, more preferably more than 10%. Specifically, it is preferable that a thin film formed of the above-mentioned electrode material in a thickness of 10 to 100 nm is used as the cathode.

The sheet resistance of the cathode is preferably a few hundred Ω/square or less. The thickness of the cathode may be generally selected from a range of 10 nm to 5 μm, and preferably 50 to 200 nm.

(Light Emitting Layer)

The light emitting layer is a layer in which holes and electrons injected from the anode and the cathode are recombined to give excitons for light emission after formation of inverted population.

A light emitting material may be used alone in the light emitting layer, but preferably, the light emitting layer contains a light emitting material and a host material. As the light emitting material, one or more selected from the compound group represented by the formula (1) of the present invention may be used. In order to lower the threshold current density in the organic semiconductor laser device of the present invention, it is important to confine the singlet excitons and the triplet excitons formed in the light emitting material inside the light emitting material. Accordingly, a host material is preferably used in addition to the light emitting material in the light emitting layer. The host material may be such an organic compound that at least any one of the excited singlet energy and the excited triplet energy thereof is higher than that of the compound represented by the formula (1) used as the light emitting material. As a result, the single excitons and the triplet excitons formed in the light emitting material can be confined inside the molecules of the light emitting material to thereby further lower the threshold current density for laser emission. Needless-to-say, even though the single excitons and the triplet excitons could not be sufficiently confined, threshold reduction and improvement of laser characteristics could be realized as the case may be, and therefore a host material capable of realizing threshold reduction and improvement of laser characteristics can be used with no specific limitation. In the organic semiconductor laser device of the present invention, layer emission occurs from the compound represented by the formula (1) contained as the light emitting material therein. The laser light may be light of amplified spontaneous emission or light of stimulated

emission from external irradiation light. The light from the light emitting layer may contain the light emitted from the host material.

In the case where a host material is used, the content of the compound represented by the formula (1), which is a light emitting material in the light emitting layer, is preferably 0.1% by weight or more, more preferably 1% by weight or more, and is preferably 50% by weight or less, more preferably 25% by weight or less, even more preferably 20% by weight or less, especially preferably 15% by weight or less.

The host material in the light emitting layer is preferably an organic compound having hole transporting performance and electron transporting performance, capable of preventing prolongation of the wavelength of light emission and having a high glass transition temperature.

(Injection Layer)

The injection layer is a layer that is provided between the electrode and the organic layer, for decreasing the driving voltage and enhancing the light emission luminance, and includes a hole injection layer and an electron injection layer, which may be provided between the anode and the light-emitting layer or the hole transport layer and between the cathode and the electron transport layer. The injection layer may be provided depending on necessity.

(Blocking Layer)

The blocking layer is a layer that is capable of inhibiting charges (electrons or holes) and/or excitons present in the light-emitting layer from being diffused outside the light-emitting layer. The electron blocking layer may be disposed between the light-emitting layer and the hole transport layer, and inhibits electrons from passing through the light-emitting layer toward the hole transport layer. Similarly, the hole blocking layer may be disposed between the light-emitting layer and the electron transport layer, and inhibits holes from passing through the light-emitting layer toward the electron transport layer. The blocking layer may also be used for inhibiting excitons from being diffused outside the light-emitting layer. Thus, the electron blocking layer and the hole blocking layer each may also have a function as an exciton blocking layer. The term "the electron blocking layer" or "the exciton blocking layer" referred to herein is intended to include a layer that has both the functions of an electron blocking layer and an exciton blocking layer by one layer.

(Hole Blocking Layer)

The hole blocking layer has the function of an electron transport layer in a broad sense. The hole blocking layer has a function of inhibiting holes from reaching the electron transport layer while transporting electrons, and thereby enhances the recombination probability of electrons and holes in the light-emitting layer. As the material for the hole blocking layer, the material for the electron transport layer to be mentioned below may be used optionally.

(Electron Blocking Layer)

The electron blocking layer has the function of transporting holes in a broad sense. The electron blocking layer has a function of inhibiting electrons from reaching the hole transport layer while transporting holes, and thereby enhances the recombination probability of electrons and holes in the light-emitting layer.

(Exciton Blocking Layer)

The exciton blocking layer is a layer for inhibiting excitons generated through recombination of holes and electrons in the light-emitting layer from being diffused to the charge transporting layer, and the use of the layer inserted enables effective confinement of excitons in the light-emitting layer, and thereby enhances the light emission efficiency of the device. The exciton blocking layer may be inserted adjacent to the light-emitting layer on any of the side of the anode and the side of the cathode, and on both the sides. Specifically, in the case where the exciton blocking layer is present on the side of the anode, the layer may be inserted between the hole transport layer and the light-emitting layer and adjacent to the light-emitting layer, and in the case where the layer is inserted on the side of the cathode, the layer may be inserted between the light-emitting layer and the cathode and adjacent to the light-emitting layer. Between the anode and the exciton blocking layer that is adjacent to the light-emitting layer on the side of the anode, a hole injection layer, an electron blocking layer and the like may be provided, and between the cathode and the exciton blocking layer that is adjacent to the light-emitting layer on the side of the cathode, an electron injection layer, an electron transport layer, a hole blocking layer and the like may be provided. In the case where the blocking layer is provided, at least one of the excited singlet energy and the excited triplet energy of the material used as the blocking layer is preferably higher than the excited singlet energy and the excited triplet energy of the light-emitting layer, of the light-emitting material.

(Hole transport Layer)

The hole transport layer is formed of a hole transport material having a function of transporting holes, and the hole transport layer may be provided as a single layer or plural layers.

The hole transport material has one of injection or transporting property of holes and blocking property of electrons, and may be any of an organic material and an inorganic material. Examples of known hole transport materials that may be used herein include a triazole derivative, an oxadiazole derivative, an imidazole derivative, a carbazole derivative, an indolocarbazole derivative, a polyarylalkane derivative, a pyrazoline derivative, a pyrazolone derivative, a phenylenediamine derivative, an arylamine derivative, an amino-substituted chalcone derivative, an oxazole derivative, a styrylanthracene derivative, a fluorenone derivative, a hydrazone derivative, a stilbene derivative, a silazane derivative, an aniline copolymer and an electroconductive polymer oligomer, particularly a thiophene oligomer. Among these, a porphyrin compound, an aromatic tertiary amine compound and a styrylamine compound are preferably used, and an aromatic tertiary amine compound is more preferably used.

(Electron transport Layer)

The electron transport layer is formed of a material having a function of transporting electrons, and the electron transport layer may be a single layer or may be formed of plural layers.

The electron transport material (often also acting as a hole blocking material) may have a function of transmitting the electrons injected from a cathode to a light-emitting layer. The electron transport layer usable here includes, for example, nitro-substituted fluorene derivatives, diphenylquinone derivatives, thiopyran dioxide derivatives, carbodiimides, fluorenylidenemethane derivatives, anthraquinodimethane and anthrone derivatives, oxadiazole derivatives, etc. Further, thiadiazole derivatives derived from the above-mentioned oxadiazole derivatives by substituting the oxygen atom in the oxadiazole ring with a sulfur atom, and quinoxaline derivatives having a quinoxaline ring known as an electron-attractive group are also usable as the electron transport material. Further, polymer materials prepared by introducing these materials into the polymer chain, or having these material in the polymer main chain are also usable.

(Resonator Structure)

The organic semiconductor laser device of the present invention may further have a resonator structure. The "resonator structure" is a structure for bouncing the light emitted by the light emitting layer, in the light emitting layer. With that, the light travels repeatedly in the light emitting layer to cause stimulated emission, thereby producing laser light at a higher intensity. Specifically, the resonator structure is formed of a pair of reflecting mirrors, in which, preferably, one reflecting mirror has a reflectance of 100% while the other reflecting mirror has a reflectance of 50 to 95%. The reflectance of the other reflecting mirror is set relatively low, and therefore laser light can be taken outside through the reflecting mirror. In the following, the reflecting mirror on the side through which laser light is taken out is referred to as "an output mirror". The reflecting mirror and the output mirror may be arranged separately from the layers and the members constituting the organic semiconductor laser device, or the anode and the cathode in the device may be made to have an additional function as a reflecting mirror or an output mirror.

For example, in the case where the anode is made to have an additional function as a reflecting mirror or an output mirror, preferably, the anode is formed of a metal film poorly absorbing visible light, having a high reflectance and having a relatively large work function (4.0 eV or more). Examples of such a metal film include a metal film of Ag, Pt or Au, or an alloy film containing any of these metals. The reflectance and the transmittance of the anode may be controlled to fall within a desired range by controlling the thickness of the metal film, for example, within a range of tens nm or more.

In the case where the cathode is made to have an additional function as a reflecting mirror or an output mirror, preferably, the cathode is formed of a metal film poorly absorbing visible light, having a high reflectance and having a relatively small work function. Examples of such a metal film include a metal film of Al or Mg, and an alloy film containing any of these metals. The reflectance and the transmittance of the cathode may be controlled to fall within a desired range by controlling the thickness of the metal film, for example, within a range of tens nm or more.

In the case where a reflecting mirror or an output mirror is arranged separately from the above-mentioned layers and members, preferably, a reflective film is formed between the anode and the organic layer, or between the substrate and the anode to make it function as a reflecting mirror or an output mirror.

In the case where a reflecting mirror or an output mirror is arranged between the anode and the organic layer, preferably, an electroconductive material poorly absorbing visible light, having a reflectance and having a large work function (4.0 eV or more) is used as the material for the mirror. Specifically, a metal film of a metal of Ag, Pt or Au or an alloy containing any of these metals may be used as the reflecting mirror or the output mirror. The reflectance and the transmittance of the reflecting mirror and the output mirror may be controlled to fall within a desired range by controlling

the thickness of the metal film to fall, for example, within a range of tens nm or more. Here, in the case where such a reflecting mirror or an output mirror is arranged between the anode and the organic layer, the material of the anode is not required to have a large work function, but any known electrode material falling within a broad range may be used for the anode.

In the case where a reflecting mirror or an output mirror is arranged between the substrate and the anode, preferably, the material for the mirror poorly absorbs visible light and has a high reflectance. Specifically, a metal film of a metal of Al, Ag or Pt or an alloy containing any of these metals, or a laminate film formed by laminating a Ti film on an alloy film of Al and Si, or a dielectric multilayer film of silicon oxide and titanium oxide formed alternately may be used as a reflecting mirror or an output mirror. Among these, the reflectance and the transmittance of the metal film can be controlled to fall within a desired range by controlling the thickness thereof so as to fall, for example, within a range of tens nm or more. The reflectance and the transmittance of the dielectric multilayer film may be controlled to fall within a desired range by controlling the thickness and the layering frequency of silicon oxide and titanium oxide.

A combination mode of the reflecting mirror and the output mirror includes a combination where the output mirror is an anode and the reflecting mirror is a cathode, a combination where the output mirror is a reflective film arranged between an anode and an organic layer or between a substrate and an anode, and the reflecting mirror is a cathode, a combination where the reflecting mirror is an anode and the output mirror is a cathode, and a combination where the reflecting mirror is a reflective film arranged between an anode and an organic layer or between a substrate and an anode and the output mirror is a cathode.

In such a resonator structure, preferably, the device layer configuration is so designed that the total optical thickness of the layers existing between the reflecting mirror and the output mirror (the thickness of each layer is multiplied by the refractive index thereof, and the resultant values are totaled to be the total optical thickness of the constitutive layers) could be an integral multiple of the half wavelength of the laser light. Accordingly, steady waves can be formed between the reflecting mirror and the output mirror for light amplification to thereby give laser light at a higher intensity.

In the resonator structure, laser light is bounced back and forth the in the direction vertical to the main surface of the substrate, but a resonator structure where laser light is bounced back and forth the in the direction horizontal to the main surface of the substrate may also be employed here. Based on the reflection owing to the refractive index difference between an organic layer and air, the resonator structure of the type can be so designed that the edges of the organic layer act as a reflecting mirror or an output mirror. Around the light emitting layer, diffractive grating may be arranged at a grating space of $\lambda/2n$ (where $\lambda$ is the wavelength of light, and n is an integer of 1 or more), and the light generated in the light emitting layer may be periodically reflected by the grating space of the diffractive gratings. Accordingly, a single vertical mode can be realized, and good monochromatic laser light can be emitted from the edges of the organic layer.

[Threshold value for ASE from light emitting layer]

In this description, the "threshold value for ASE" means an excited light intensity, which is measured as follows: A light emitting layer is irradiated with excitation light to measure the excitation light intensity dependence of the emission intensity thereof, then the relationship between the excitation light intensity and the emission intensity is considered to be a linear function, and the excitation light intensity at the point where the inclination of the linear function has changed is read to be the threshold value for ASE. In the following, the "threshold value for ASE" may be referred to as an "ASE threshold". Here, the target light emitting layer may be a light emitting layer that a current excitation-type organic semiconductor laser device has, or may be a light emitting layer that a photoexcitation-type organic semiconductor laser device has. The light emitting layer may be formed of a compound represented by the formula (1), or may contain a compound represented by the formula (1) and a host material. Regarding the specific measurement conditions for the "ASE threshold", reference may be made to the column of Examples.

Preferably, the ASE threshold of the light emitting layer that the organic semiconductor laser device of the present invention has is preferably 20 $\mu J/cm^2$ or less, more preferably 10 $\mu J/cm^2$ or less, even more preferably 5 $\mu J/cm^2$ or less, especially preferably 3 $\mu J/cm^2$ or less.

[Full Length at Half Maximum of Emission Peak at ASE Threshold of Light Emitting Layer]

In this description, the "full width at half maximum of the emission peak at the ASE threshold" means the full width at half maximum of the emission peak having a highest intensity, which is measured as follows: The target light emitting layer is irradiated with excitation light at an intensity corresponding to the ASE threshold value to measure the emission spectrum thereof, and among the emission peaks appearing in the emission spectrum, the emission peak having a highest intensity is analyzed to measure the full width at half maximum thereof. Here, for the target light emitting layer, reference may be made to the description of the light emitting layer for the ASE threshold value.

Preferably, the light emitting layer of the organic semiconductor laser device of the present invention is such

that the full length at half maximum of the emission peak at the ASE threshold value is less than 30 nm, more preferably less than 20 nm, and even more preferably less than 15 nm.

The organic semiconductor laser device of the type mentioned above emits laser light when a current not less than the threshold current density is made to pass between the anode and the cathode therein. At this time, the organic semiconductor laser device of the present invention contains a compound represented by the formula (1) and therefore has a low threshold current density, and accordingly can emit laser light at a relative low current density and can attain excellent laser characteristics.

In producing the organic semiconductor laser device of the present invention, a compound represented by the formula (1) may be used not only in the light emitting layer but also in any other layer than the light emitting layer. At this time, the compound of the formula (1) used in the light emitting layer may be the same as or different from the compound of the formula (1) used in any other layer than the light emitting layer. For example, a compound represented by the formula (1) may also be used in the above-mentioned injection layer, blocking layer, hole blocking layer, electron blocking layer, exciton blocking layer, hole transport layer and electron transport layer. Method for forming these layers are not specifically limited, and these layers may be formed in any of a dry process or a wet process.

## Examples

The characteristic features of the present invention will be described more specifically with reference to Examples given below. The materials, processes, procedures and the like shown below may be appropriately modified unless they deviate from the substance of the invention. Accordingly, the scope of the invention is not construed as being limited to the specific examples shown below. For evaluation of emission characteristics, used here were a fluorescence spectrophotometer (by JASCO Corporation, FP-6500-A-51), an absolute PL quantum yield measuring system (by Hamamatsu Photonics K.K., C11347-01), a streak camera (by Hamamatsu Photonics K.K., C4334), and a multichannel spectrometer (by Hamamatsu Photonics K.K., PMA-11).

The compound 1 and the compound 2 were synthesized according to the methods described in WO2015/102118.

(Evaluation of Photoluminescence Characteristic)

On a silicon substrate having a silicon oxide layer having a thickness of 1000 nm, formed was a thin film containing the compound 1 and having a thickness of 100 nm through co-evaporation of mCBP and the compound 1 from different evaporation sources thereonto according to a vacuum evaporation method at a vacuum degree of $5 \times 10^{-5}$ Pa or less. At this time, the concentration of the compound 1 in the thin film was 1% by weight.

In addition, a thin film containing 1% by weight of the compound 2 was formed under the same condition as above except that the compound 2 was used in place of the compound 1.

Each thin film was analyzed at 300 K to measure the absolute photoluminescence quantum yield $\Phi$, the photoluminescence quantum yield of the instantaneous fluorescent component $\Phi_F$, the photoluminescence quantum yield of the delayed fluorescent component $\Phi_{TADF}$, the emission lifetime of the instantaneous fluorescent component $\tau_F$, and the emission lifetime of the delayed fluorescent component $\tau_{TADF}$. The results are shown in Table 1. Here, $\Phi_F$ and $\Phi_{TADF}$ each are a value calculated by multiplying $\Phi$ by the ratio of the region corresponding to each component in the total area of the emission peak.

[Table 1]

| Type of Thin Film | $\Phi$ | $\Phi_F$ | $\Phi_{TADF}$ | $\tau_F$ (ns) | $\tau_{TADF}$ ($\mu$s) |
|---|---|---|---|---|---|
| Thin film containing 1 wt% of compound 1 | 0.897 | 0.843 | 0.054 | 6.0 | 65.3 |
| Thin film containing 1 wt% of compound 2 | 0.880 | 0.845 | 0.035 | 8.8 | 93.7 |

As shown in Table 1, delayed fluorescence emission was observed from each thin film, which confirms that the compound 1 and the compound 2 are thermal activation-type delayed fluorescent materials.

(Example 1) Production and evaluation of organic semiconductor laser device using compound 1

On a silicon substrate having a silicon oxide layer having a thickness of 1000 nm, formed was a thin film of the compound 1 (hereinafter referred to as "single film") in a thickness of 85 nm or 100 nm according to a vacuum evaporation method at a vacuum degree of $5 \times 10^{-5}$ Pa or less, thereby producing two organic semiconductor laser devices differing from each other in the thickness of the thin film therein.

Apart from these, a thin film having a thickness of 100 nm was formed on a silicon substrate having a silicon oxide layer having a thickness of 1000 nm through co-evaporation from different evaporation sources of the compound 1 and mCBP according to a vacuum evaporation method at a vacuum degree of 5 $\times$ $10^{-5}$ Pa or less (hereinafter the film is referred to as "doped film"), thereby producing an organic semiconductor laser device. At this time, the concentration of the compound in the doped film was changed to be 1% by weight, 6% by weight, 15% by weight, 25% by weight or 50% by weight, thereby producing five kinds of organic semiconductor laser devices differing from each other in the concentration of the compound 1 therein.

The organic semiconductor laser device having, as formed therein, a single film of the compound 1 in a thickness of 85 nm was analyzed with 337-nm excitation light to measure the PL spectrum and the ASE spectrum thereof, which are shown in Fig. 2, and the excitation light intensity dependency of the emission intensity and the full width at half maximum (FWHM) of the emission peak of the device is shown in Fig. 3. In Fig. 2, the spectrum at the indicated excitation light intensity (unit: $\mu J/cm^2$) is the ASE spectrum measured at the excitation light intensity. The PL spectrum was measured with an ambient light at 337 nm. The excitation light intensity used for measurement of the PL spectrum in the even-numbered figures of Figs. 4 to 14 is the same as that in Fig. 2.

The organic semiconductor laser device having, as formed therein, a single film of the compound 1 in a thickness of 100 nm was analyzed with 337-nm excitation light to measure the PL spectrum and the ASE spectrum thereof, which are shown in Fig. 4, and the excitation light intensity dependency of the emission intensity of the device is shown in Fig. 5. The ASE spectrum in Fig. 4 was measured at a fixed excitation light intensity of 100 $\mu J/cm^2$.

The organic semiconductor laser device having a doped film with 1 wt% of the compound 1 was analyzed with 337-nm excitation light to measure the PL spectrum and the ASE spectrum thereof, which are shown in Fig. 6, and the excitation light intensity dependency of the emission intensity and the full width at half maximum (FWHM) of the emission peak of the device is shown in Fig. 7. The ASE spectrum in Fig. 6 was measured at a fixed excitation light intensity of 5 $\mu J/cm^2$.

The organic semiconductor laser device having a doped film with 6 wt% of the compound 1 was analyzed with 337-nm excitation light to measure the PL spectrum and the ASE spectrum thereof, which are shown in Fig. 8, and the excitation light intensity dependency of the emission intensity and the full width at half maximum (FWHM) of the emission peak of the device is shown in Fig. 9. The ASE spectrum in Fig. 8 was measured at a fixed excitation light intensity of 5 $\mu J/cm^2$.

The organic semiconductor laser device having a doped film with 15 wt% of the compound 1 was analyzed with 337-nm excitation light to measure the PL spectrum and the ASE spectrum thereof, which are shown in Fig. 10, and the excitation light intensity dependency of the emission intensity of the device is shown in Fig. 11. The ASE spectrum in Fig. 10 was measured at a fixed excitation light intensity of 5 $\mu J/cm^2$.

The organic semiconductor laser device having a doped film with 25 wt% of the compound 1 was analyzed with 337-nm excitation light to measure the PL spectrum and the ASE spectrum thereof, which are shown in Fig. 12, and the excitation light intensity dependency of the emission intensity of the device is shown in Fig. 13. The ASE spectrum in Fig. 12 was measured at a fixed excitation light intensity of 5 $\mu J/cm^2$.

The organic semiconductor laser device having a doped film with 50 wt% of the compound 1 was analyzed with 337-nm excitation light to measure the PL spectrum and the ASE spectrum thereof, which are shown in Fig. 14, and the excitation light intensity dependency of the emission intensity of the device is shown in Fig. 15. The ASE spectrum in Fig. 14 was measured at a fixed excitation light intensity of 5 $\mu J/cm^2$.

In Figs. 3, 5, 7, 9, 11, 13 and 15, the full lines are approximation straight lines that are approximated to the measured points plotted therein, and the the excitation light intensity at the point at which the inclination of the approximation straight lines changes corresponds to the threshold value for ASE (ASE threshold value). The ASE threshold and the maximum wavelength of ASE read in the figures are shown in Table 2.

[Table 2]

| Type of thin film in organic semiconductor laser device | ASE Threshold ($\mu J/cm^2$) | Maximum Wavelength of ASE (nm) |
|---|---|---|
| Single film of compound 1 (thickness 85 nm) | 42 | 499 |
| Single film of compound 1 (thickness 100 nm) | 16.6 | 502 |
| Doped film with 1 wt% of compound 1 (thickness 100 nm) | 2.6 | 487 |
| Doped film with 6 wt% of compound 1 (thickness 100 nm) | 1.7 | 487 |
| Doped film with 15 wt% of compound 1 (thickness 100 nm) | 2.4 | 497 |

(continued)

| Type of thin film in organic semiconductor laser device | ASE Threshold (μJ/cm$^2$) | Maximum Wavelength of ASE (nm) |
|---|---|---|
| Doped film with 25 wt% of compound 1 (thickness 100 nm) | 4.4 | 499 |
| Doped film with 50 wt% of compound 1 (thickness 100 nm) | 9.8 | 500 |

The odd-numbered figures of Figs. 3 to 15 are referred to. It is known that the emission intensity of each organic semiconductor laser device increases depending on the excitation light intensity and according to a linear function, but during the increase, the inclination changes. Figs. 3, 7 and 9 are referred to. It is known that the full width at half maximum of the emission peak noticeably decreases depending on the excitation light intensity. These results indicate that the ASE expresses at the point at which the inclination of the emission intensity increase has changed, and the excitation light intensity at that point corresponds to the threshold value for ASE. As shown in Table 2, the ASE threshold of each organic semiconductor laser device derived from the figures is not more than 20 μJ/cm$^2$ and is low, and in particular, the organic semiconductor devices where the doped film contained 1 to 25% by weight of the compound 1 attained an extremely low threshold value of 1.7 to 4.4 μJ/cm$^2$. The even-numbered figures of Figs. 2 to 14 are referred to. All the produced organic semiconductor laser devices had a steep peak in the ASE spectrum thereof measured at an excitation light intensity of not less than the ASE threshold value, and were confirmed to have excellent laser characteristics.

(Example 2) Production and evaluation of organic semiconductor laser device using compound 2

A thin film having a thickness of 100 nm was formed on a silicon substrate having a silicon oxide layer having a thickness of 1000 nm through evaporation from different evaporation sources of the compound 2 and mCBP according to a vacuum evaporation method at a vacuum degree of $5 \times 10^{-5}$ Pa or less, in which the concentration of the compound 2 in the thin film formed was 6.0% by weight, thereby producing an organic semiconductor laser device.

The organic semiconductor laser device produced in Example 2 was irradiated with 337 nm excitation light at 5 μJ/cm$^2$ to measure the ASE spectrum thereof, which is shown in Fig. 16, and the excitation light intensity dependence of the emission intensity of the device is shown in Fig. 17.

As shown in Fig. 16, the organic semiconductor laser device also had a steep peak in the ASE spectrum thereof, and was confirmed to have excellent laser characteristics. The ASE threshold value derived from Fig. 17 was 2.8 ± 0.3 μJ/cm$^2$, that is, the device realized such an extremely low threshold value.

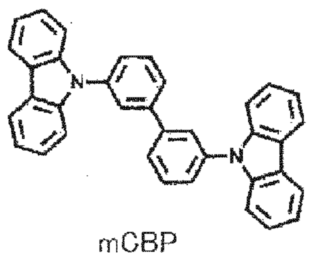

mCBP

Industrial Applicability

The organic semiconductor laser device of the present invention has a low threshold value for laser emission and has excellent laser characteristics, and therefore the present invention is applicable not only to a photoexcitation-type organic semiconductor laser device but also to a current excitation-type organic semiconductor laser device, and the industrial applicability of the present invention is great.

Reference Signs List

1 Substrate

2 Anode
3 Hole Injection Layer
4 Hole Transport Layer
5 Light Emitting Layer
6 Electron Transport Layer
7 Cathode

## Claims

**1.** An organic semiconductor laser device comprising a compound represented by the following formula (1):

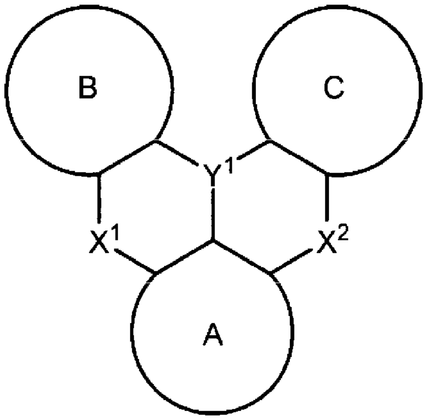

(1)

wherein:

the ring A, the ring B and the ring C each independently represent an aryl ring or a heteroaryl ring, and at least one hydrogen in these rings may be substituted;
$Y^1$ represents B, P, P=O, P=S, Al, Ga, As, Si-R or Ge-R, and R in Si-R and Ge-R represents an aryl group or an alkyl group,
$X^1$ and $X^2$ each independently represent O, N-R, S or Se, R in N-R represents an optionally substituted aryl group, an optionally substituted heteroaryl group, or an alkyl group, and R in N-R may bond to at least one of the ring A, the ring B and the ring C via a linking group or a single bond, and
at least one hydrogen atom in the compound or the structure represented by the formula (1) may be substituted with a halogen atom or a deuterium atom.

**2.** The organic semiconductor laser device according to claim 1, wherein in the formula (1):

the ring A, the ring B and the ring C each independently represent an aryl ring or a heteroaryl ring, and at least one hydrogen in these rings may be substituted with a substituted or unsubstituted aryl group, a substituted or unsubstituted heteroaryl group, a substituted or unsubstituted diarylamino group, a substituted or unsubstituted diheteroarylamino group, a substituted or unsubstituted arylheteroarylamino group, a substituted or unsubstituted alkyl group, a substituted or unsubstituted alkoxy group, or a substituted or unsubstituted aryloxy group, and these rings each have a 5-membered ring or a 6-membered ring that shares a bond with the fused bicyclic structure formed of $Y^1$, $X^1$ and $X^2$ in the center of the formula,
$Y^1$ represents B, P, P=O, P=S, Al, Ga, As, Si-R or Ge-R, and R in Si-R and Ge-R represents an aryl group or an alkyl group,
$X^1$ and $X^2$ each independently represent O, N-R, S or Se, R in N-R represents an aryl group optionally substituted with an alkyl group or an aryl group, a heteroaryl group optionally substituted with an alkyl group, or an alkyl group, and R in N-R may bond to at least one of the ring A, the ring B and the ring C via -O-, -S-, $-C(-R)_2-$ or a single bond, and R in $-C(-R)_2-$ represents a hydrogen atom or an alkyl group, and
at least one hydrogen atom in the compound or the structure represented by the formula (1) may be substituted with a halogen atom or a deuterium atom.

**3.** The organic semiconductor laser device according to claim 1, wherein the compound represented by the formula

(1) is a compound represented by the following formula (2):

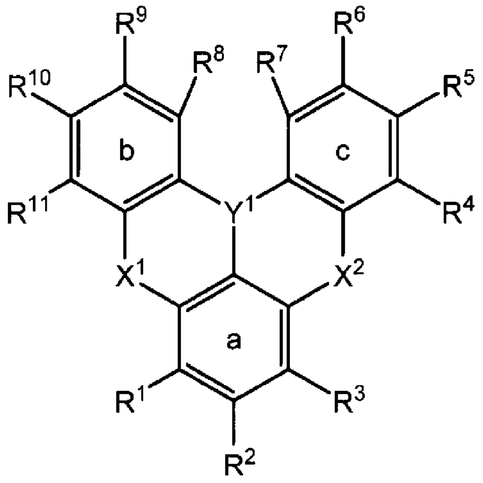

(2)

wherein:

$R^1$, $R^2$, $R^3$, $R^4$, $R^5$, $R^6$, $R^7$, $R^8$, $R^9$, $R^{10}$ and $R^{11}$ each independently represent a hydrogen atom, an aryl group, a heteroaryl group, a diarylamino group, a diheteroarylamino group, an arylheteroarylamino group, an alkyl group, an alkoxy group or an aryloxy group, at least one hydrogen atom in these may be substituted with an aryl group, a heteroaryl group or an alkyl group, adjacent groups among $R^1$ to $R^{11}$ may bond to each other to form an aryl ring or a heteroaryl ring along with the ring a, the ring b or the ring c, at least one hydrogen atom in the formed ring may be substituted with an aryl group, a heteroaryl group, a diarylamino group, a diheteroarylamino group, an arylheteroarylamino group, an alkyl group, an alkoxy group or an aryloxy group, and at least one hydrogen atom in these may be substituted with an aryl group, a heteroaryl group or an alkyl group,

$Y^1$ represents B, P, P=O, P=S, Al, Ga, As, Si-R or Ge-R, R in Si-R and Ge-R represents an aryl group having 6 to 12 carbon atoms or an alkyl group having 1 to 6 carbon atoms,

$X^1$ and $X^2$ each independently represent O, N-R, S or Se, R in N-R represents an aryl group having 6 to 12 carbon atoms, a heteroaryl group having 2 to 15 carbon atoms, or an alkyl group having 1 to 6 carbon atoms, R in N-R may bond to at least one of the ring a, the ring b and the ring c via -O-, -S-, $-C(-R)_2-$ or a single bond, and R in $-C(-R)_2-$ represents an alkyl group having 1 to 6 carbon atoms, and

at least one hydrogen atom in the compound represented by the formula (2) may be substituted with a halogen atom or a deuterium atom.

**4.** The organic semiconductor laser device according to claim 3, wherein in the formula (2):

$R^1$, $R^2$, $R^3$, $R^4$, $R^5$, $R^6$, $R^7$, $R^8$, $R^9$, $R^{10}$ and $R^{11}$ each independently represent a hydrogen atom, an aryl group having 6 to 30 carbon atoms, a heteroaryl group having 2 to 30 carbon atoms, or a diarylamino group (provided that the aryl group is an aryl group having 6 to 12 carbon atoms), and adjacent groups among $R^1$ to $R^{11}$ may bond to each other to form an aryl ring having 9 to 16 carbon atoms or a heteroaryl ring having 6 to 15 carbon atoms along with the ring a, the ring b or the ring c, and at least one hydrogen atom in the formed ring may be substituted with an aryl group having 6 to 10 carbon atoms,

$Y^1$ represents B, P, P=O, P=S or Si-R, R in Si-R represents an aryl group having 6 to 10 carbon atoms or an alkyl group having 1 to 4 carbon atoms,

$X^1$ and $X^2$ each independently represent O, N-R or S, R in N-R represents an aryl group having 6 to 10 carbon atoms or an alkyl group having 1 to 4 carbon atoms, and

at least one hydrogen atom in the compound represented by the formula (2) may be substituted with a halogen atom or a deuterium atom.

**5.** The organic semiconductor laser device according to claim 3, wherein in the formula (2), $Y^1$ is B.

**6.** The organic semiconductor laser device according to claim 3 or 5, wherein in the formula (2), $X^1$ and $X^2$ each are N-R, and R is an aryl group optionally substituted with an aryl group.

7. The organic semiconductor laser device according to any one of claims 3, 5 and 6, wherein in the formula (2), at least one of $R^4$ to $R^6$ is a diarylamino group, and at least one of $R^9$ to $R^{11}$ is an aryl group.

8. The organic semiconductor laser device according to claim 7, wherein among $R^1$, $R^2$, $R^3$, $R^4$, $R^5$, $R^6$, $R^7$, $R^8$, $R^9$, $R^{10}$ and $R^{11}$ in the formula (2), at least one of $R^4$ to $R^6$ is a diarylamino group, at least one of $R^9$ to $R^{11}$ is an aryl group, and the other(s) is(are) hydrogen atom(s).

9. The organic semiconductor laser device according to any one of claims 1 to 8, which is a photoexcitation-type organic semiconductor laser device.

10. The organic semiconductor laser device according to any one of claims 1 to 8, which is a current excitation-type organic semiconductor laser device.

11. The organic semiconductor laser device according to claim 10, which has a light emitting layer arranged between an anode and a cathode and wherein the light emitting layer contains the compound represented by the formula (1).

12. The organic semiconductor laser device according to claim 11, wherein the concentration of the compound represented by the formula (1) in the light emitting layer is 1 to 25% by weight relative to the total weight of the light emitting layer.

[Fig. 1]

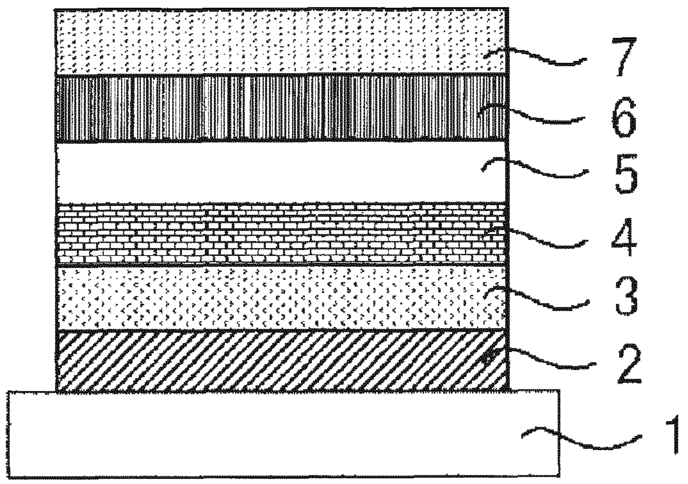


[Fig. 2]

Single film of compound 1 (85 nm)

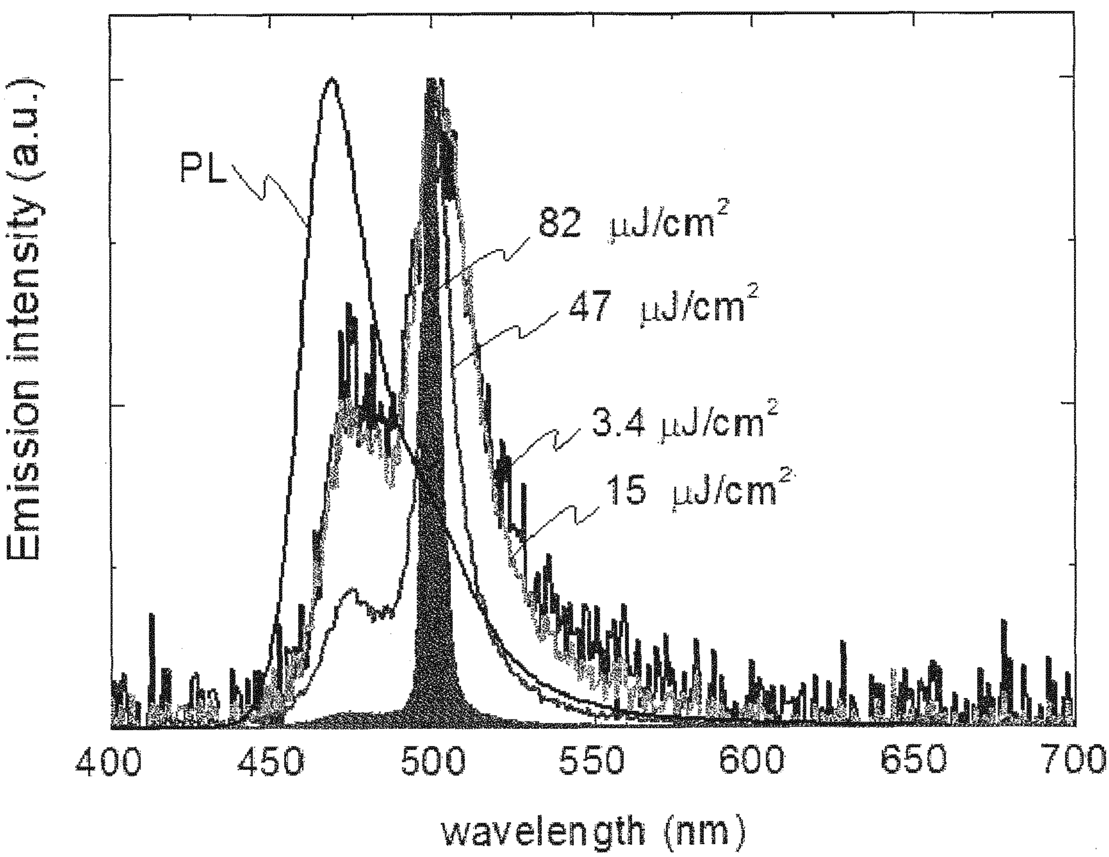

[Fig. 3]

Single film of compound 1 (85 nm)

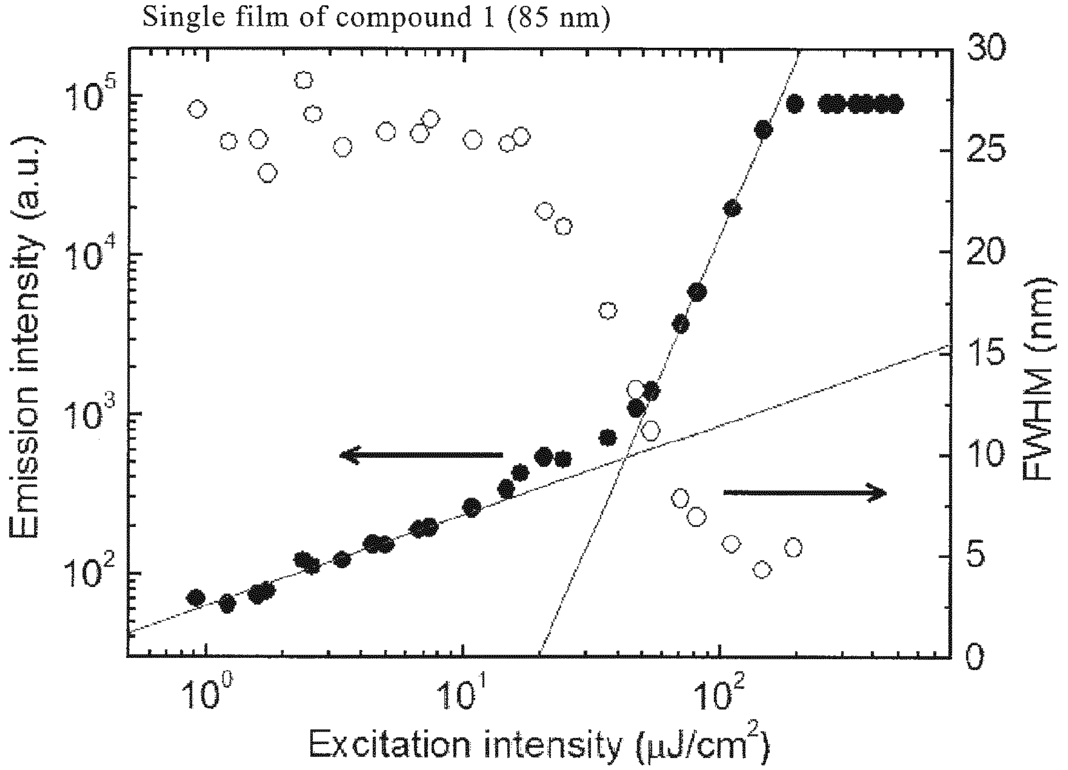


[Fig. 4]

Single film of compound 1 (100 nm)

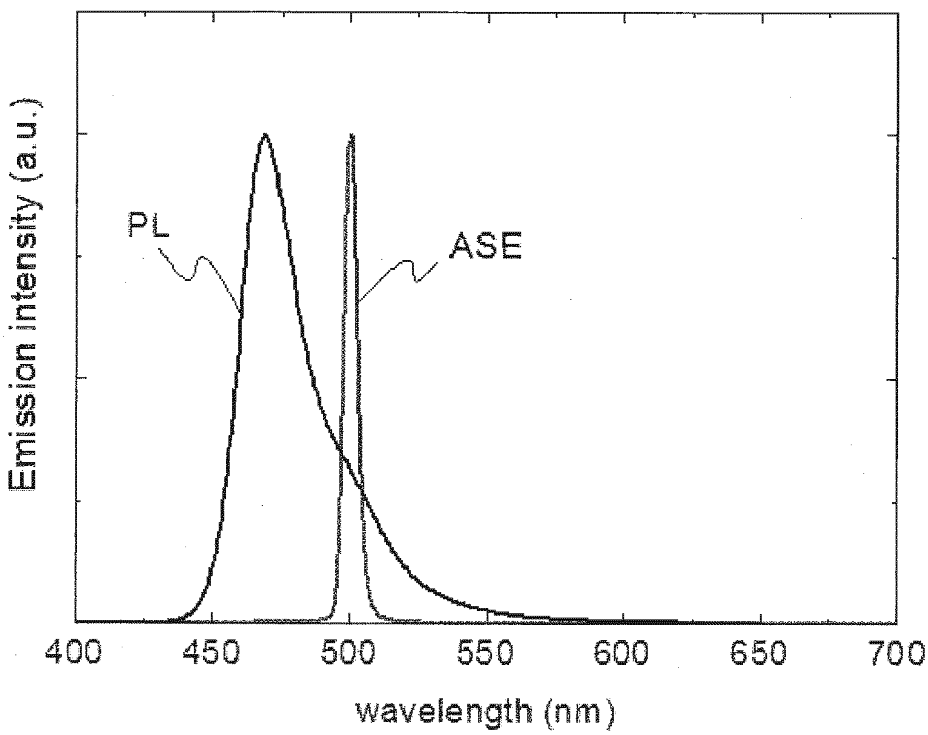

[Fig. 5]

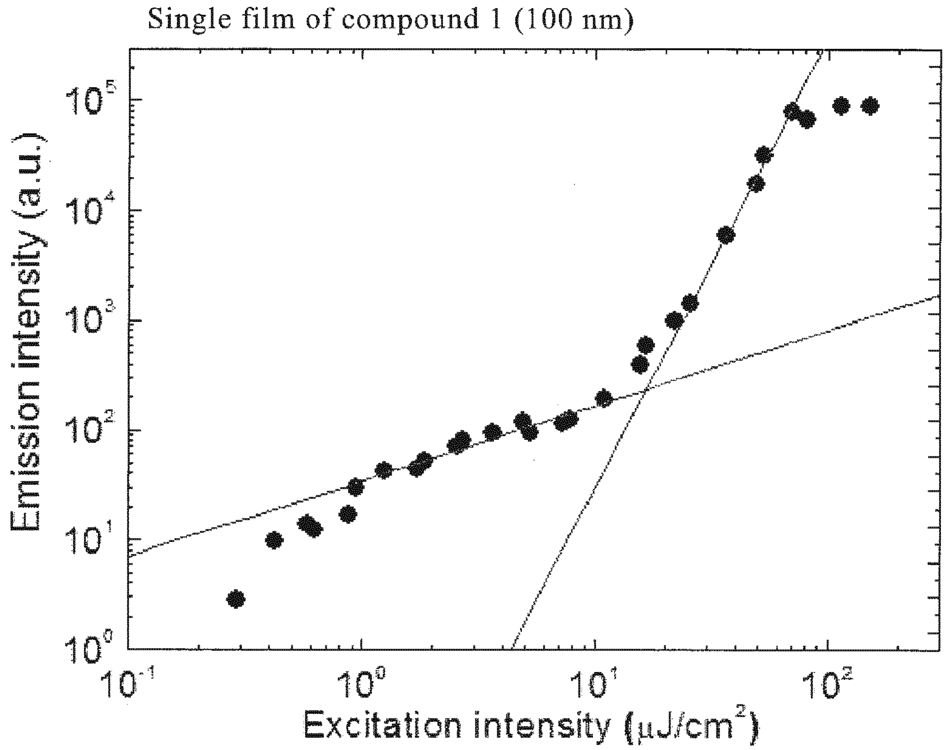
Single film of compound 1 (100 nm)
$10^5$
$10^4$
$10^3$
$10^2$
$10^1$
$10^0$
Emission intensity (a.u.)
$10^{-1}$
$10^0$
$10^1$
$10^2$
Excitation intensity (μJ/cm$^2$)

[Fig. 6]

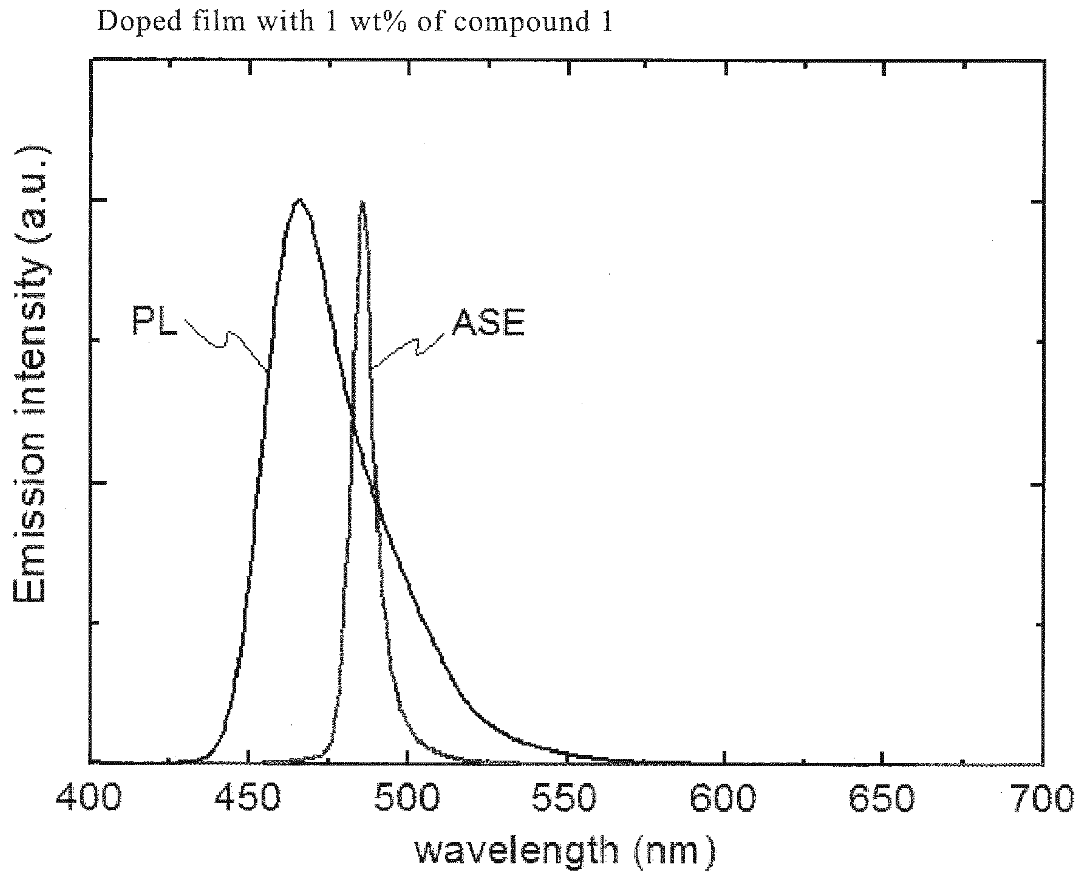
Doped film with 1 wt% of compound 1
Emission intensity (a.u.)
PL
ASE
400
450
500
550
600
650
700
wavelength (nm)

[Fig. 7]

Doped film with 1 wt% of compound 1

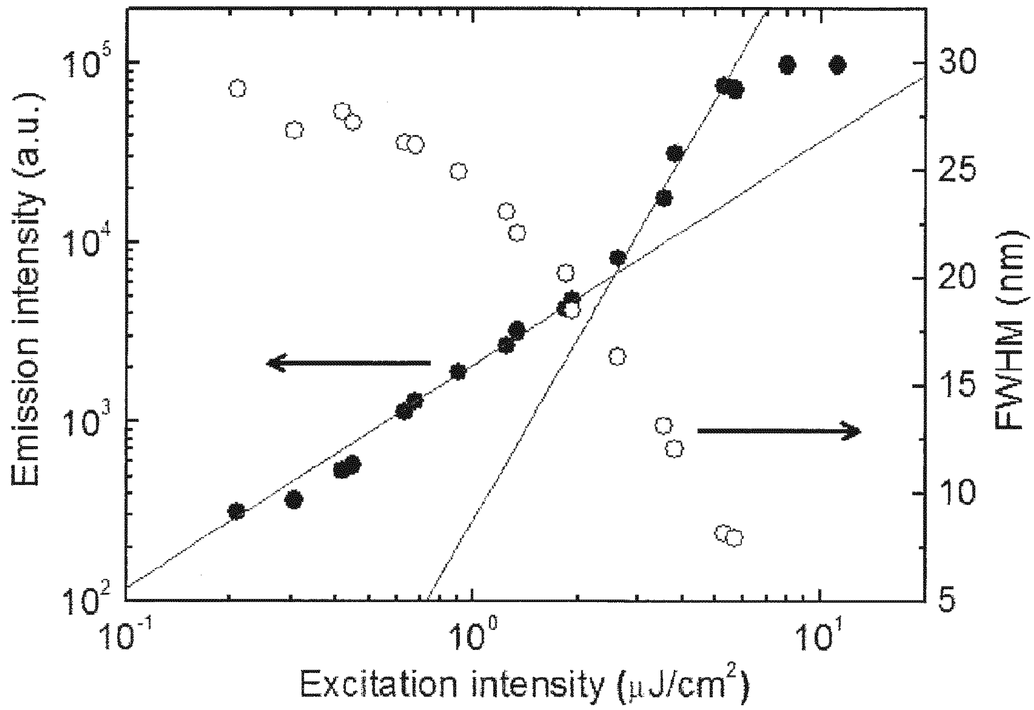


[Fig. 8]

Doped film with 6 wt% of compound 1

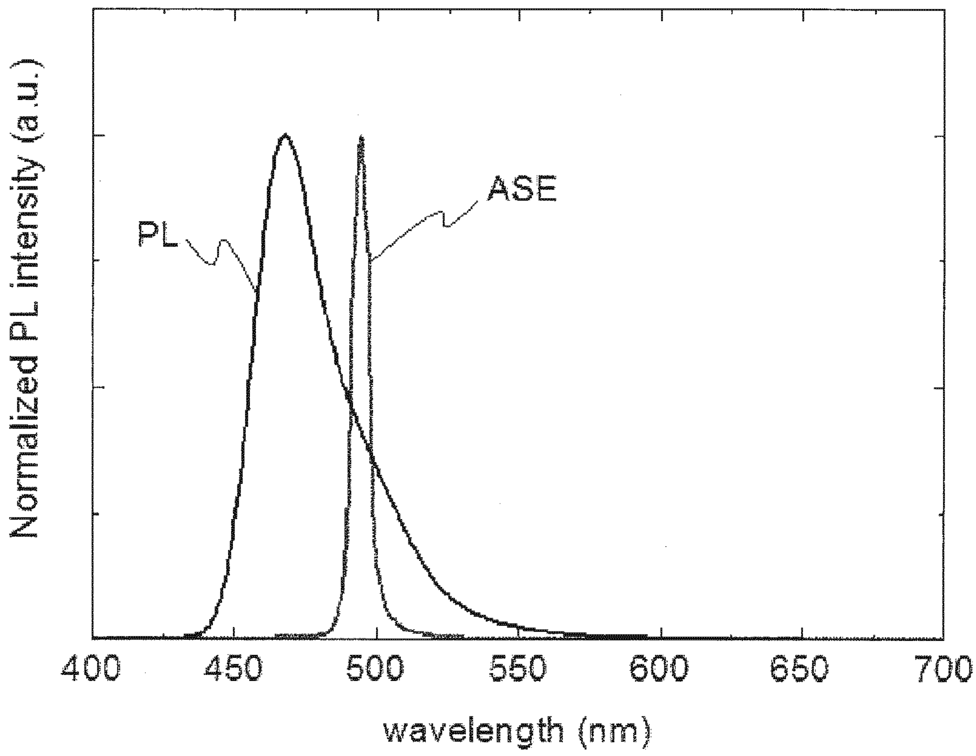

[Fig. 9]

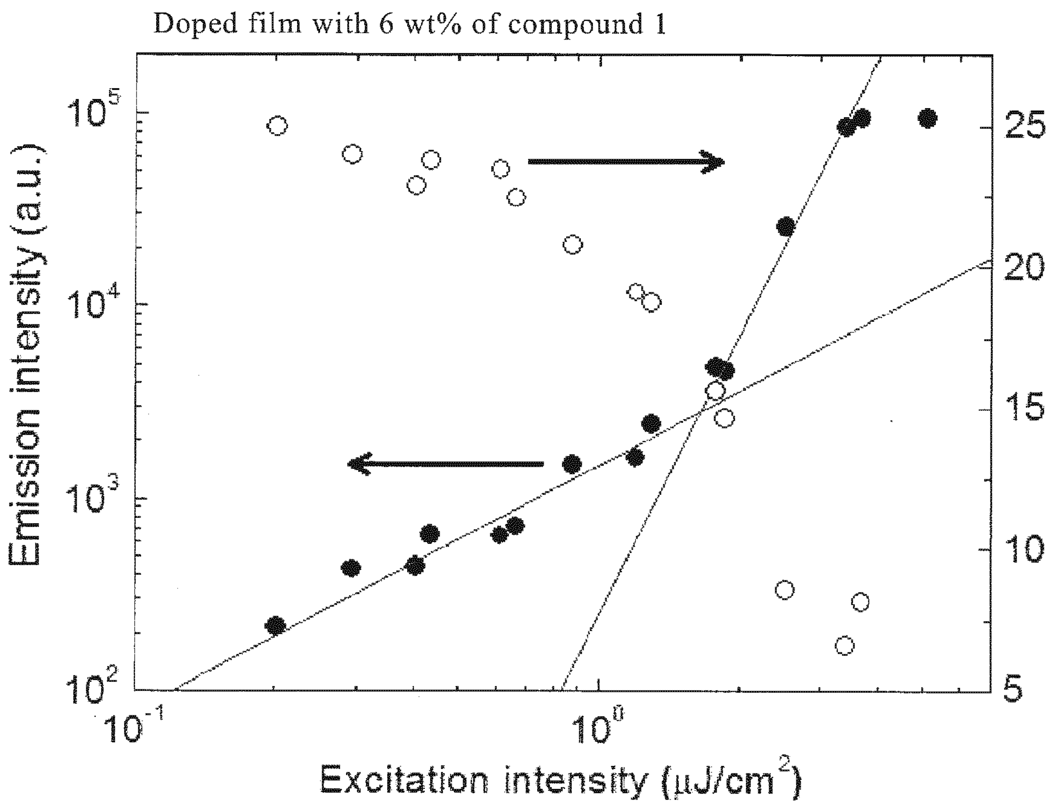
Doped film with 6 wt% of compound 1
Emission intensity (a.u.)
FWHM (nm)
Excitation intensity (μJ/cm$^2$)
$10^5$
$10^4$
$10^3$
$10^2$
$10^{-1}$
$10^0$
25
20
15
10
5

[Fig. 10]

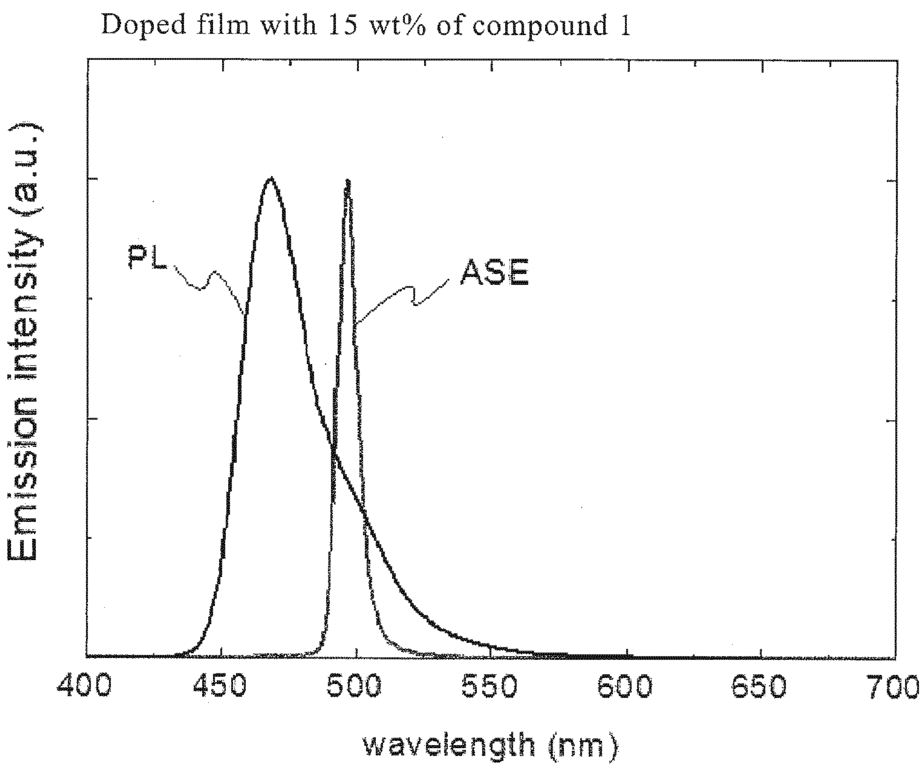
Doped film with 15 wt% of compound 1
Emission intensity (a.u.)
PL
ASE
400
450
500
550
600
650
700
wavelength (nm)

[Fig. 11]

Doped film with 15 wt% of compound 1

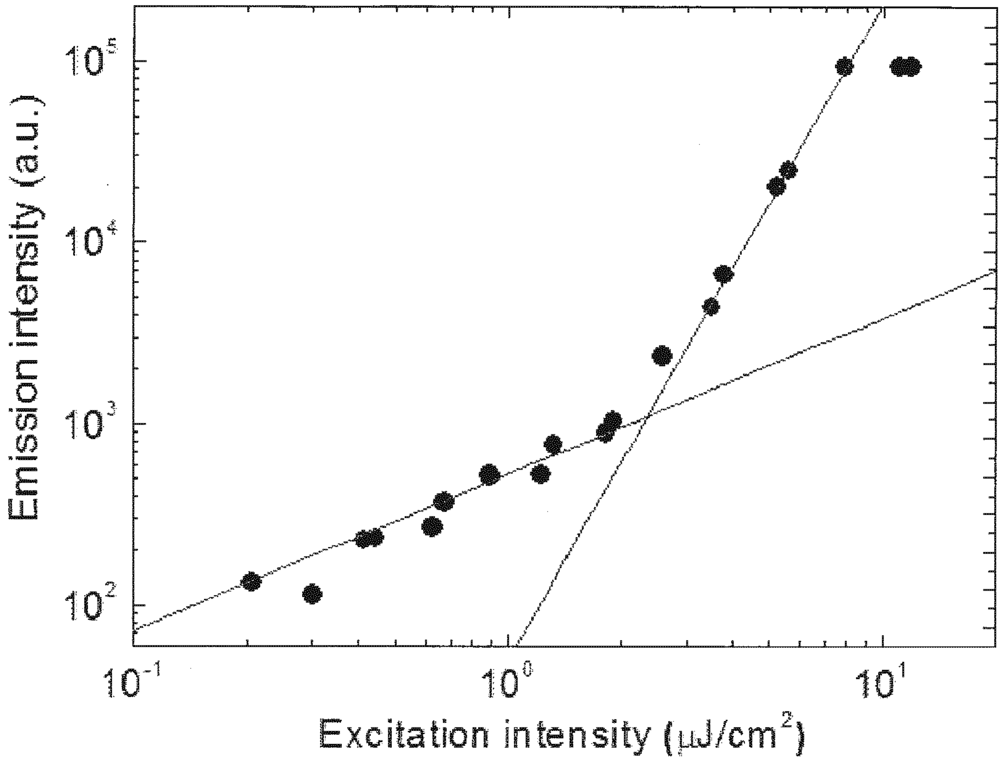


[Fig. 12]

Doped film with 25 wt% of compound 1

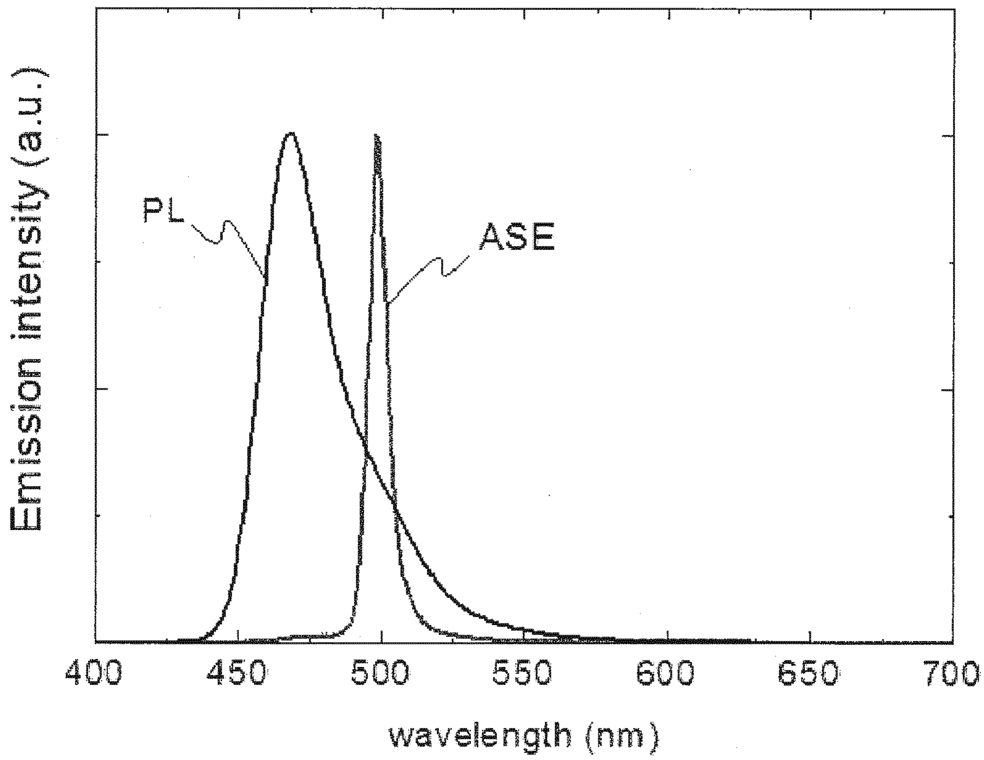

[Fig. 13]

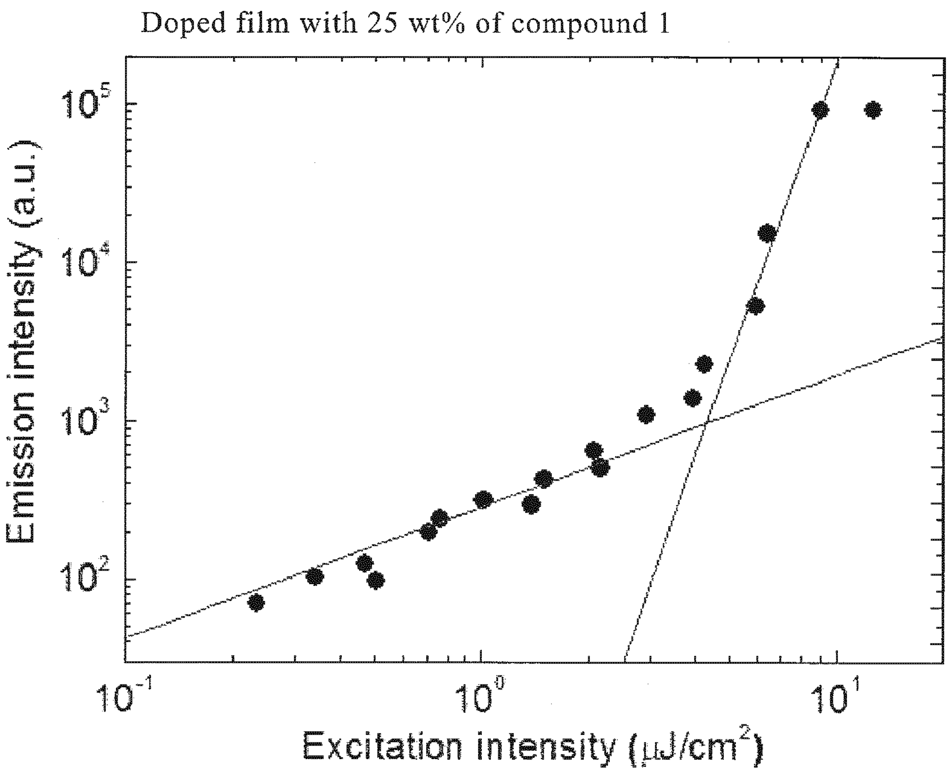
Doped film with 25 wt% of compound 1
Emission intensity (a.u.)
$10^5$
$10^4$
$10^3$
$10^2$
$10^{-1}$
$10^0$
$10^1$
Excitation intensity (μJ/cm$^2$)

[Fig. 14]

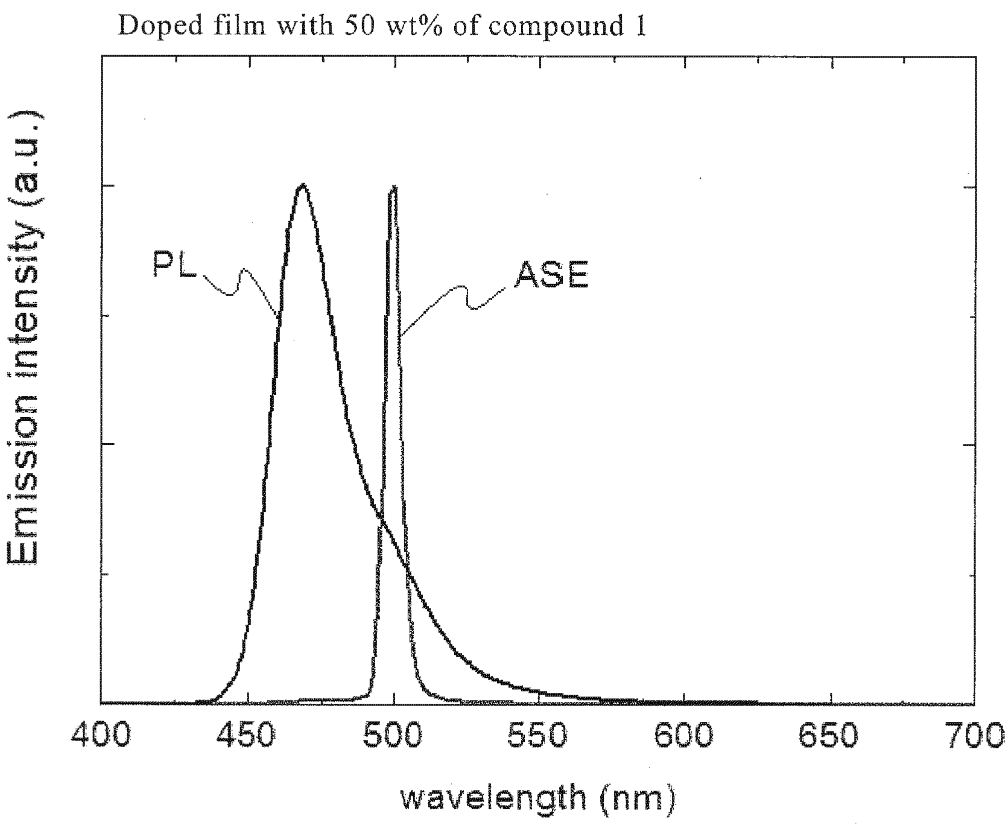
Doped film with 50 wt% of compound 1
Emission intensity (a.u.)
PL
ASE
400
450
500
550
600
650
700
wavelength (nm)

[Fig. 15]

Doped film with 50 wt% of compound 1

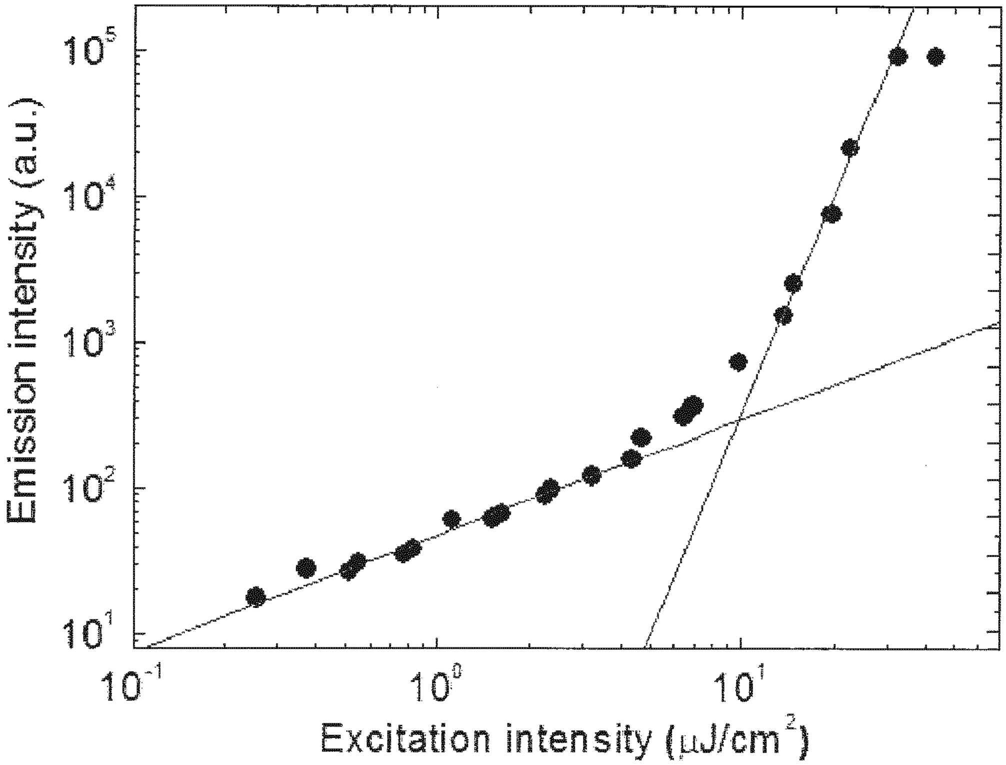


[Fig. 16]

Doped film with 6 wt% of compound 2

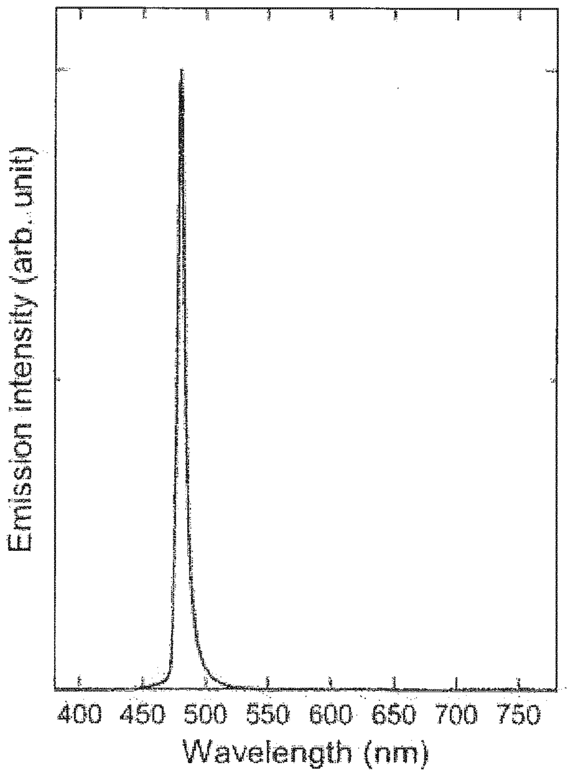

[Fig. 17]

Doped film with 6 wt% of compound 2

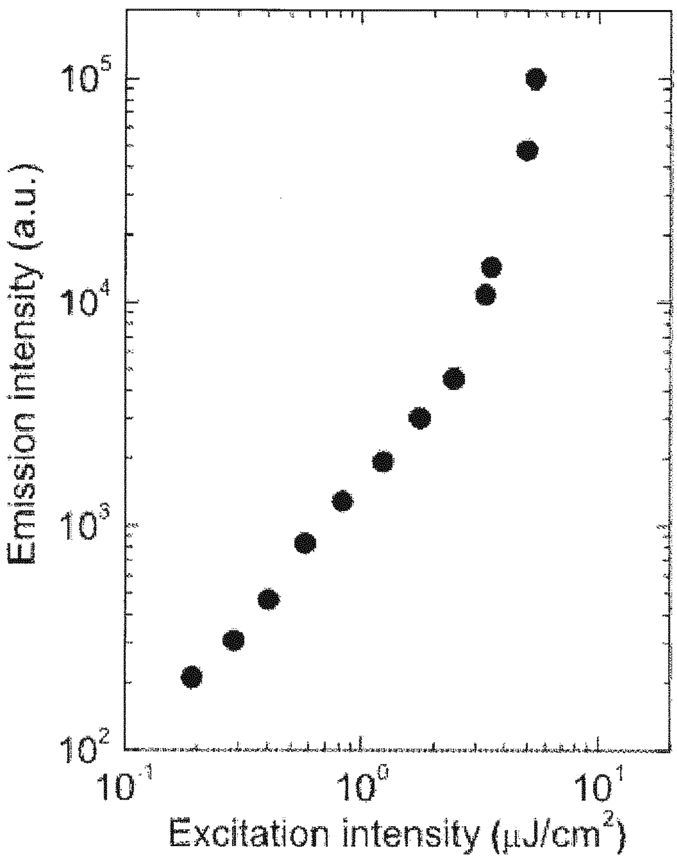

## INTERNATIONAL SEARCH REPORT

International application No.
PCT/JP2018/011288

A. CLASSIFICATION OF SUBJECT MATTER
Int.Cl. H01S5/36(2006.01)i, C09K11/06(2006.01)i, H01L51/50(2006.01)i

According to International Patent Classification (IPC) or to both national classification and IPC

B. FIELDS SEARCHED

Minimum documentation searched (classification system followed by classification symbols)
Int.Cl. H01S5/36, C09K11/06, H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2015/102118 A1 (KWANSEI GAKUIN EDUCATIONAL FOUNDATION) 09 July 2015, claims, examples, paragraphs [0318]-[0388], fig. 1 & US 2015/0236274 A1, fig. 1 & EP 3109253 A1 & CN 105431439 A & KR 10-2016-0119683 A & TW 201538513 A | 1-12 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10.05.2018 | 22.05.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2018/011288

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2016-25209 A (KYUSHU UNIVERSITY) 08 February 2016, paragraphs [0189]-[0224], fig. 2 & US 2017/0163010 A1, fig. 2 & WO 2016/010136 A1 & EP 3171421 A1 & CN 106537630 A & KR 10-2017-0036706 A | 1-12 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2015102118 A


### Non-patent literature cited in the description


- **SOROKIN, P. P. ; LANKARD, J. R.** *IBM J. Res. Develop.,* 1966, vol. 10, 162-163
- **SCHAFER, F. P. ; SCHMIDT, W. ; VOLZE.** *J. Appl. Phys. Lett.,* 1966, vol. 9, 306-309
- **SOFFER B. H. ; MCFARLAND, B. B.** *Appl. Phys. Lett.,* 1967, vol. 10, 266-267
- **SOROKIN, P. P. ; LANKARD, J. R. ; MORUZZI, V. L. ; HAMMOND, E. C.** *J. Chem. Phys.,* 1968, vol. 48, 4726-4741
- **SOROKIN, P. P. ; LANKARD, J. R. ; MORUZZI, V. L. ; LURIO, A.** *Appl. Phys. Lett.,* 1969, vol. 15, 179-181
- **CHIHAYA ADACHI.** Student Advanced technical paper. *Nippon Kogyo Shimbun,* 1989
- **TESSLER, N. ; DENTON, G. J. ; FRIEND, R. H.** *Nature,* 1996, vol. 382, 695-697
- **FROLOV, S. V. ; OZAKI, M. ; GELLERMANN, W. ; VARDENY, Z. V. ; YOSHINO, K.** *Jpn. J. Appl. Phys.,* 1996, vol. 35, L1371-L1373
- **HIDE, F. ; DIAZ-GARCIA, M. A. ; SCHWARTZ, B. J. ; ANDERSSON, M. R. ; PEI, Q. ; HEEGER, A. J.** *Science,* 1996, vol. 273, 1833-1836
- **KOZLOV, V. G. ; BULOVIC, V. ; BURROWS, P. E. ; FORREST, S. R.** *Nature,* 1997, vol. 389, 362-364
- **BERGGREN, M. ; DODABALAPUR, A. ; SLUSHER, R. E. ; BAO, Z.** *Nature,* 1997, vol. 389, 466-469